# EUROPEAN PATENT APPLICATION

(11) **EP 1 282 165 A2**
(43) Date of publication of application: **05.02.2003**
(21) Application number: 02291912.0
(22) Date of filing: 29.07.2002
(51) Int. Cl.: H01L 21/768

(54) **Semiconductor device and manufacturing method thereof**

(30) Priority: 30.07.2001 JP 2001230600
(71) Applicant: NEC CORPORATION, Tokyo (JP)
(72) Inventor: Nambu Hidetaka, Tokyo (JP)
(74) Representative: Simonnet, Christine

(57) **Abstract**

A dual damascene structure with high fabricating precision capable of reducing inter-wiring capacitance arising from interlayer insulating films is realized. In a semiconductor device, a via interlayer insulating film and a wiring interlayer insulating film through which a via plug and upperlayer wiring are formed, respectively, are made of organic films having low permittivity. The wiring interlayer insulating film is covered by a hard mask made of a SiO₂ film.

## Description

### BACKGROUND OF THE INVENTION

The present invention relates to a semiconductor device and a method for manufacturing the same, and in particular, to a semiconductor device having a dual damascene wiring structure obtained by simultaneously forming a via plug and wiring in a via interlayer insulating film and a wiring interlayer insulating film, respectively, the films being formed over a semiconductor substrate, and a method for manufacturing the same.

### Description of the Related Art

Recently, the size of individual semiconductor elements has been increasingly miniaturized as the degree of integration of LSI (large scale integration) such as a microprocessor and a memory known as typical semiconductor devices has been improved. Accordingly, in the semiconductor device, the area provided with each semiconductor element (semiconductor area) becomes smaller. When forming wiring to connect each semiconductor area, it is impossible to obtain high density of wiring in conformity to the high degree of integration if wiring is formed only on surfaces of a semiconductor substrate in a horizontal direction. To obtain higher density of wiring in the semiconductor device, there is employed a multilevel interconnection technique for forming wiring through a plurality of layers in perpendicular direction. For example, a multilevel interconnection structure through seven to nine layers is realized in typical LSI such as a microprocessor.

In such LSI, since characteristics such as working speed, etc. largely depend on a resistance value of wiring, wiring with a lower resistance value is required. As a wiring material for a semiconductor device including LSI, Al that excels in electrical characteristics, workability, etc. or an Al alloy such as a metal having Al as its component has been commonly used. However, the Al base alloys have a fault that they are inferior in electro-migration resistance, stress-migration resistance, etc. Consequently, there is a tendency to employ Cu, which also excels in such resistance, having a smaller resistance value than that of Al or a Cu alloy such as a metal having Cu as its component as a substitute for Al.

Incidentally, when forming wiring with a Cu alloy, it is difficult to pattern the metal into a desired shape by an etch technique, while the technique is suitable for etching the Al alloys, because the Cu alloys are chemically stable. Therefore, when forming wiring with a Cu alloy, there is employed a damascene wiring technique in which, after a wiring trench is formed in advance through an interlayer insulating film made over a semiconductor substrate and a film of a Cu alloy is formed on the surfaces to fill in the wiring trench, unnecessary part of the film above the insulating film is removed by a CMP (chemical mechanical polishing) method to leave the Cu alloy only in the wiring trench, which is to be used as wiring. Moreover, as multilevel interconnection structure suitable for miniaturized wiring, there is employed a dual damascene wiring structure, which has evolved from the damascene technique.

The dual damascene wiring structure is obtained as follows. After stacking a via interlayer insulating film and a wiring interlayer insulating film over a semiconductor substrate above which underlayer wiring is formed in advance, a via hole and an upperlayer wiring trench are formed through the interlayer insulating films, respectively, and a film of a Cu alloy is formed thereover. Subsequently, unnecessary part of the film is removed by the CMP method to leave the metal only in the via hole and the upperlayer wiring trench, thus enabling a via plug and upperlayer wiring to be simultaneously formed. By this means, there is obtained the dual damascene wiring structure in which the underlayer wiring and the upperlayer wiring are connected to each other through the via plug.

In a semiconductor device having such dual damascene wiring structure, the increase of inter-wiring capacitance (hereinafter also referred to as "capacitance" simply), which stems from the interlayer insulating films between the underlayer and upperlayer wiring, causes signal delay and bad influence on fast performance. To reduce the capacitance, an insulating film having low permittivity (namely, low-K) tends to be used for the respective interlayer insulating films.

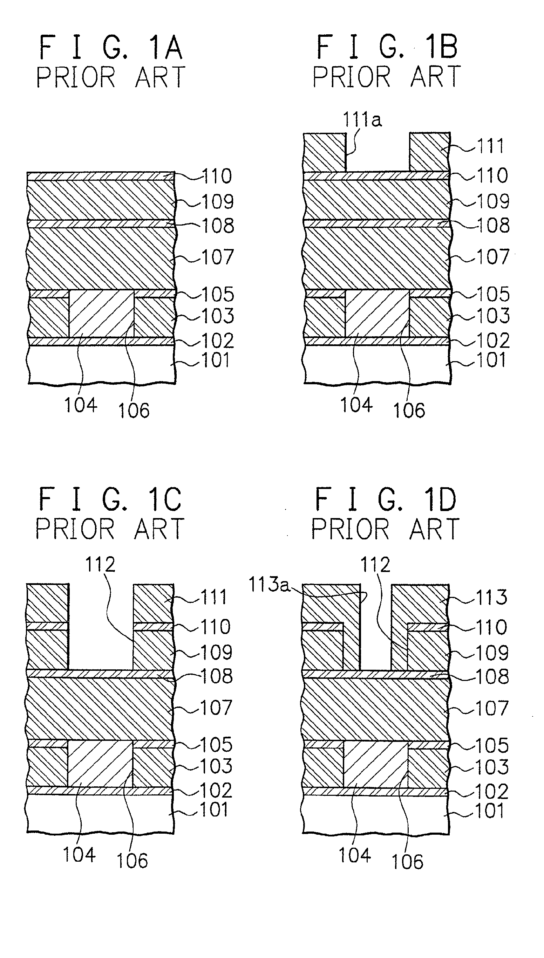

A method for manufacturing a semiconductor device having the above-described dual damascene wiring structure is disclosed in Japanese Patent Application Laid-Open No. HEI10-209273, for example. In the following, an explanation will be given of the procedure for manufacturing the semiconductor device according to the above method referring to Figs. 1A through 1G.

First, as shown in Fig. 1A, a first interlayer insulating film 103 such as a SiO₂ (silicon dioxide) film and a first etching stopper film 105 such as SiN (silicon nitride) film are formed on a semiconductor substrate 101 in/on which predetermined elements (not shown) and an insulating film 102 such as a SiO₂ film are formed. After the first insulating film 103 and the first etching stopper film 105 are selectively etched to form an underlayer wiring trench 106, a conductive film such as a Cu film is formed thereon so as to fill in the underlayer wiring trench 106. Then, the conductive film is eliminated until the etching stopper film 105 is exposed to leave the conductive film only in the wiring trench 106, thus obtaining an underlayer wiring 104. Thereafter, there are stacked on the surfaces a second interlayer insulating film 107 such as a SiO₂ film, or the like, a second etching stopper film 108 such as a SiN film, or the like, a third interlayer insulating film 109 such as a SiO₂ film, or the like, and a third etching stopper film 110 such as an Al₂O₃ (alumina) film, or the like in this order.

Subsequently, as shown in Fig. 1B, after the third etching stopper film 110 is coated with resist, the resist is exposed and developed to form a resist film 111 having an opening 111a in a desired shape.

Thereafter, as shown in Fig. 1C, the third etching stopper film 110 and the third interlayer insulating film 109 are etched in this order by using the resist film 111 as a mask until the second etching stopper film 108 is exposed. Thereby, a wiring trench 112 is obtained.

Then, as shown in Fig. 1D, after the resist film 111 is removed and the third etching stopper film 110 is coated with new resist, the resist is exposed and developed to form a resist film 113 having an opening 113a in a desired through-hole shape.

Thereafter, as shown in Fig. 1E, the second etching stopper film 108 and the second interlayer insulating film 107 are etched in this order by using the resist film 113 as a mask to form a through hole (via hole) 114.

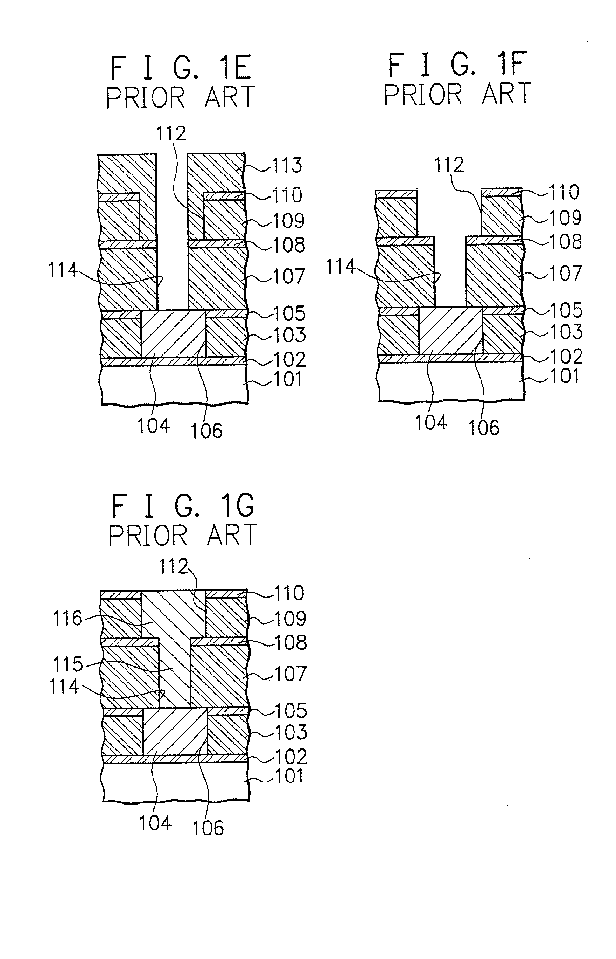

After that, as shown in Fig. 1F, after the resist film 113 is removed, a conductive film such as a Cu film is formed on the third etching stopper film 110 so as to fill in the wiring trench 112 and the through hole 114. Subsequently, the conductive film on the third etching stopper film 110 is removed by the CMP method. By this means, a via plug 115 and an upperlayer wiring 116 are simultaneously obtained as shown in Fig. 1G. By such configuration, there is completed a semiconductor device having the dual damascene structure in which the underlayer wiring 104 and the upperlayer wiring 116 are connected to each other through the via plug 115.

However, in the method for manufacturing a semiconductor device disclosed in the above application, the via hole varies widely in width (diameter) when forming the via hole antecedent to forming the via plug. This makes it difficult to realize the dual damascene structure with higher fabricating precision.

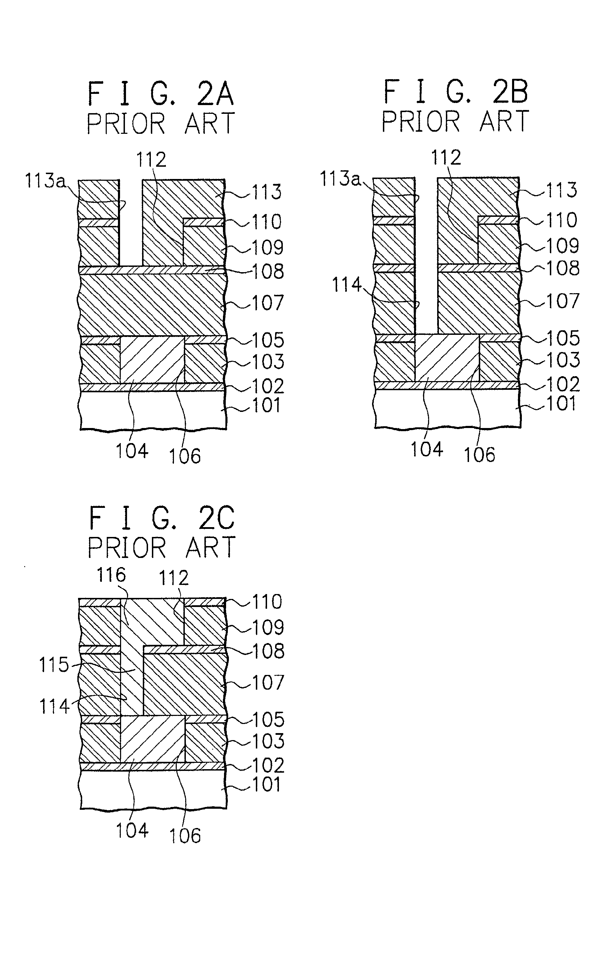

For example, in the process shown in Fig. 1D, if the resist film 113 (the opening 113a) is incorrectly formed to the left as shown in Fig. 2A, the structure after etching the second etching stopper film 108 and the second interlayer insulating film 107, which corresponds to the process shown in Fig. 1E, is as shown in Fig. 2B wherein the width of the via hole 114 becomes narrow. Accordingly, the width of the via plug 115 that is to be formed in the via hole 114 becomes narrow as shown in Fig. 2C, and thereby, it becomes impossible to obtain the dual damascene wiring structure having miniaturized wiring structure with higher fabricating precision.

Moreover, in the prior method, the insulating film such as the SiO₂ film (its permittivity is from 3.9 to 4.2) or the SiN film (its permittivity is from 7.2 to 7.6) is employed for the second interlayer insulating film 107 or the second etching stopper film 108, either of which is located between the underlayer wiring 104 and the upperlayer wiring 116. The permittivity of the respective insulating films is comparatively large, thereby leading to increase of capacitance. Consequently, the signal delay occurs to adversely affects the fast operation. Therefore, it is required to use an insulating film having lower permittivity.

### SUMMARY OF THE INVENTION

It is therefore an object of the present invention to provide a semiconductor device and a method for manufacturing the same which realize a dual damascene wiring structure with higher fabricating precision and in which inter-wiring capacitance arising from interlayer insulating films can be reduced.

According to a first aspect of the present invention, for achieving the objects mentioned above, there is provided a semiconductor device, wherein:
an interlayer insulating film is formed over an underlayer wiring;
a via plug and an upperlayer wiring are almost simultaneously formed in a via hole and a wiring trench, respectively, that are formed through the interlayer insulating film;
the underlayer wiring and the upperlayer wiring are linked through the via plug; and
the interlayer insulating film is an insulating film having low permittivity and covered by a hard mask.

According to a second aspect of the present invention, in the first aspect, the interlayer insulating film is an organic film.

According to a third aspect of the present invention, there is provided a semiconductor device, wherein:
a first interlayer insulating film and a second interlayer insulating film are stacked over an underlayer wiring in this order:
   a via plug and an upperlayer wiring are almost simultaneously formed in a via hole and a wiring trench, respectively, that are formed through the respective first and the second interlayer insulating films;
   the underlayer wiring and the upperlayer wiring are linked through the via plug;
   both of the first and the second interlayer insulating films are insulating films having low permittivity; and
   the second interlayer insulating film is covered by a hard mask.

According to a fourth aspect of the present invention, in the third aspect, at least one of the first and the second interlayer insulating films is an organic film.

According to a fifth aspect of the present invention, in the fourth aspect, when one of the first and the second interlayer insulating films is the organic film, the other interlayer insulating film is an inorganic film.

According to a sixth aspect of the present invention, in one of the third to fifth aspects, at least one of the first and the second interlayer insulating films is evened by using a chemical mechanical polishing method.

According to a seventh aspect of the present invention, in one of the third to sixth aspects, a stopper film is further formed in between the first interlayer insulating film and the second interlayer insulating film.

According to an eighth aspect of the present invention, in one of the third to seventh aspects, the stopper film is evened by using a chemical mechanical polishing method.

According to a ninth aspect of the present invention, in one of the first to eighth aspects, the hard mask is a dual hard mask in which two different kinds of materials are stacked as a lower film and an upper film.

According to a tenth aspect of the present invention, in the ninth aspect, the two different materials are employed to acquire etching selectivity between the upper film and the lower film and etching selectivity between the upper film and the interlayer insulating film disposed immediately under the lower film.

According to an eleventh aspect of the present invention, in the ninth aspect, the upper film is made of at least one material selected from SiC, SiN, SiCN, W, WSi, SiOF, hydrogen-silsesquioxane, methyl-silsesquioxane, and methyl-hydrogen-silsesquioxane.

According to a twelfth aspect of the present invention, in the ninth aspect, the lower film is made of at least one material selected from SiO₂, SiC, SiN, SiCN, W, WSi, SiOF, hydrogen-silsesquioxane, methyl-silsesquioxane, and methyl-hydrogen-silsesquioxane.

According to a thirteenth aspect of the present invention, in one of the seventh to twelfth aspects, the stopper film is made of at least one material selected from SiO₂, SiN, SiCN, SiC, SiOF, hydrogen-silsesquioxane, methyl-silsesquioxane, and methyl-hydrogen-silsesquioxane.

According to a fourteenth aspect of the present invention, in one of the first to thirteenth aspects, a cap film is formed on the underlayer wiring.

According to a fifteenth aspect of the present invention, in the fourteenth aspect, the cap film is made of one material selected from SiON, SiC, SiO₂, SiCN or SiN.

According to a sixteenth aspect of the present invention, there is provided a method for manufacturing a semiconductor device wherein an interlayer insulating film is formed over an underlayer wiring, a via plug and an upperlayer wiring are almost simultaneously formed in a via hole and a wiring trench, respectively, that are formed through the interlayer insulating film, and the underlayer wiring and the upperlayer wiring are linked through the via plug, comprising:
an interlayer insulating film forming step for forming the interlayer insulating film on a cap film over the underlayer wiring;
a dual hard mask forming step for forming a dual hard mask in which two different kinds of materials are stacked as a lower film and an upper film on the interlayer insulating film;
an interlayer insulating film fabricating step for almost simultaneously forming the via hole and the wiring trench through the interlayer insulating film with the use of the dual hard mask as an etch mask; and
a wiring forming step for almost simultaneously forming the via plug and the upperlayer wiring in the via hole and the wiring trench, respectively.

According to a seventeenth aspect of the present invention, in the sixteenth aspect, the interlayer insulating film forming step includes:
a first interlayer insulating film forming step for forming a first interlayer insulating film on the cap film; and
a second interlayer insulating film forming step for forming a second interlayer insulating film over the first interlayer insulating film.

According to an eighteenth aspect of the present invention, in the sixteenth or seventeenth aspect, one material selected from SiON, SiC, SiO₂, SiCN or SiN is used for the cap film.

According to a nineteenth aspect of the present invention, in the eighteenth aspect, when using the SiO₂ as the cap film, the interlayer insulating film fabricating step is conducted with the use of etching gas including C₄F₄, CO, Ar, and O₂, C₄F₈, C₅F₈, and/or CHF₃.

According to a twentieth aspect of the present invention, in one of the sixteenth to nineteenth aspects, at least one material selected from SiC, SiN, SiCN, W, WSi, SiOF, hydrogen-silsesquioxane, methyl-silsesquioxane, and methyl-hydrogen-silsesquioxane is used for the upper film of the dual hard mask.

According to a twenty-first aspect of the present invention, in one of the sixteenth to twentieth aspect, at least one material selected from SiO₂, SiC, SiN, SiCN, W, WSi, SiOF, hydrogen-silsesquioxane, methyl-silsesquioxane, and methyl-hydrogen-silsesquioxane is used for the lower film of the dual hard mask.

According to a twenty-second aspect of the present invention, in the twentieth or the twenty-first aspect, when using the SiC and/or the SiO₂ as the upper film and the lower film, respectively, the interlayer insulating film fabricating step is conducted with the use of etching gas including CF₄, O₂ and N₂ in the respective ranges of 20 to 40 standard cubic centimeters per minute, 10 to 50 standard cubic centimeters per minute, and 80 to 150 standard cubic centimeters per minute under a condition where pressure is 10 to 100 mTorr.

### BRIEF DESCRIPTION OF THE DRAWING

The objects and features of the present invention will become more apparent from the consideration of the following detailed description taken in conjunction with the accompanying drawings in which:
Figs. 1A to 1G are process diagrams showing processes for manufacturing a conventional semiconductor device in sequence;
Figs. 2A to 2C are process diagrams for explaining a problem in the conventional semiconductor device;
Fig. 3 is a cross sectional view showing a structure of a semiconductor device according to a first embodiment of the present invention;
Fig. 4 is a cross sectional view showing an initial structure for forming a dual hard mask used in the semiconductor device;
Figs. 5A to 5C are process diagrams showing processes of making a trench mask employed for forming the dual hard mask used in the semiconductor device in sequence;
Fig. 6 is a cross sectional view showing the dual hard mask used in the semiconductor device;
Fig. 7 is a graph showing a relationship between a flow rate (horizontal axis) of N₂ that is one of the components of etching gas used when forming the dual hard mask and a selectivity ratio (vertical axis);
Fig. 8 is a graph showing a relationship between pressure (horizontal axis) in atmosphere in etching executed when forming the dual hard mask and a selectivity ratio (vertical axis);
Figs. 9A to 9E are process diagrams showing processes for manufacturing the semiconductor device in sequence;
Fig. 10 is a cross sectional view showing a structure of a semiconductor device according to a sixth embodiment of the present invention;
Fig. 11 is a cross sectional view showing an initial structure for forming a dual hard mask used in the semiconductor device;
Figs. 12A to 12C are process diagrams showing processes of making a trench mask employed for forming the dual hard mask used in the semiconductor device in sequence;
Fig. 13 is a cross sectional view showing the dual hard mask used in the semiconductor device;
Figs. 14A to 14E are process diagrams showing processes for manufacturing the semiconductor device in sequence;
Fig. 15 is a cross sectional view showing a structure of a semiconductor device according to a ninth embodiment of the present invention;
Fig. 16 is a cross sectional view showing an initial structure for forming a dual hard mask used in the semiconductor device;
Figs. 17A to 17C are process diagrams showing processes of making a trench mask employed for forming the dual hard mask used in the semiconductor device in sequence;
Fig. 18 is a cross sectional view showing the dual hard mask used in the semiconductor device;
Figs. 19A to 19E are process diagrams showing processes for manufacturing the semiconductor device in sequence;
Fig. 20 is a cross sectional view showing a structure of a semiconductor device according to a tenth embodiment of the present invention;
Fig. 21 is a cross sectional view showing an initial structure for forming a dual hard mask used in the semiconductor device;
Figs. 22A to 22C are process diagrams showing processes of making a trench mask employed for forming the dual hard mask used in the semiconductor device in sequence;
Fig. 23 is a cross sectional view showing the dual hard mask used in the semiconductor device; and
Figs. 24A to 24F are process diagrams showing processes for manufacturing the semiconductor device.

### DESCRIPTION OF THE PREFERRED EMBODIMENTS

Referring now to the drawings, embodiments of the present invention are explained in detail.

### [First Embodiment]

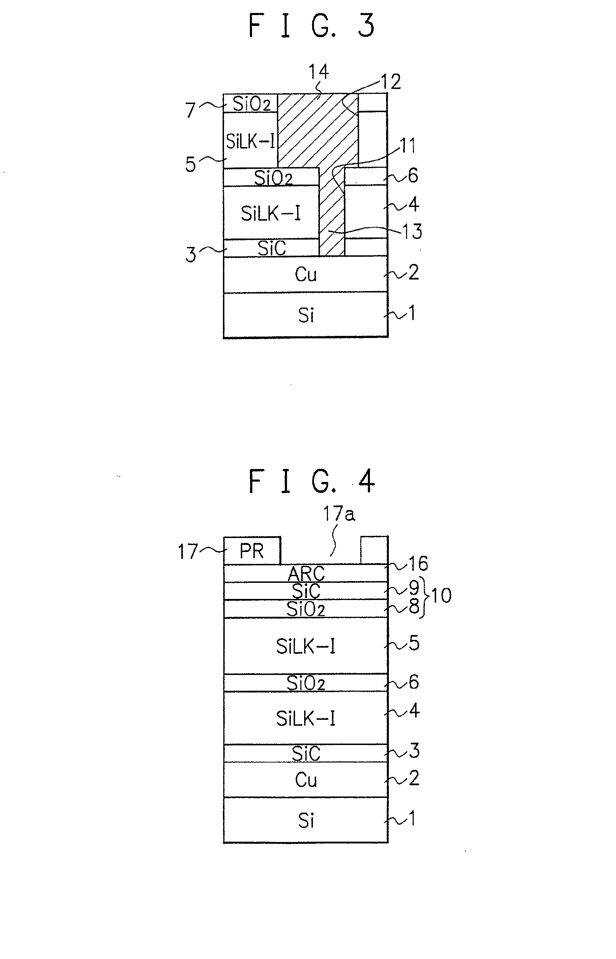

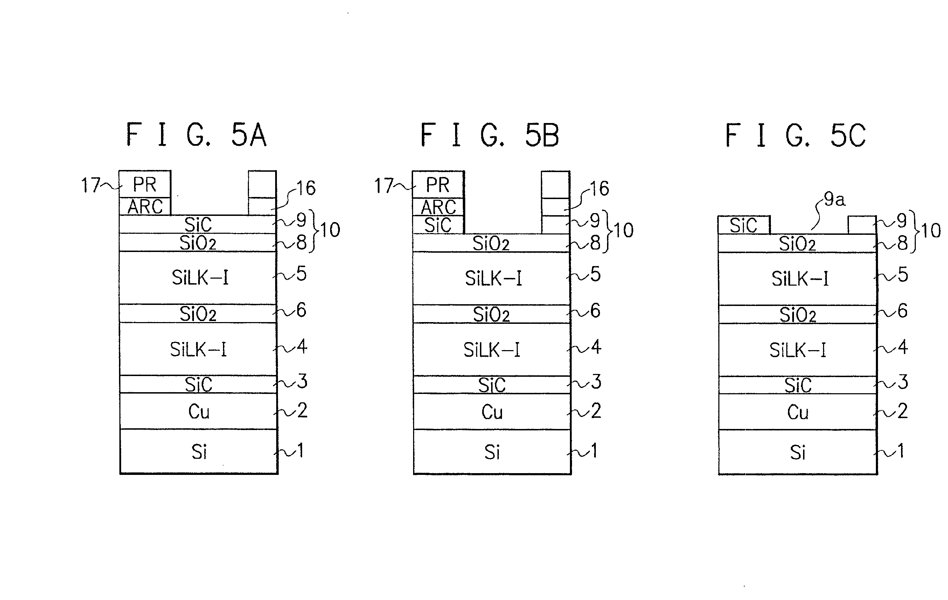

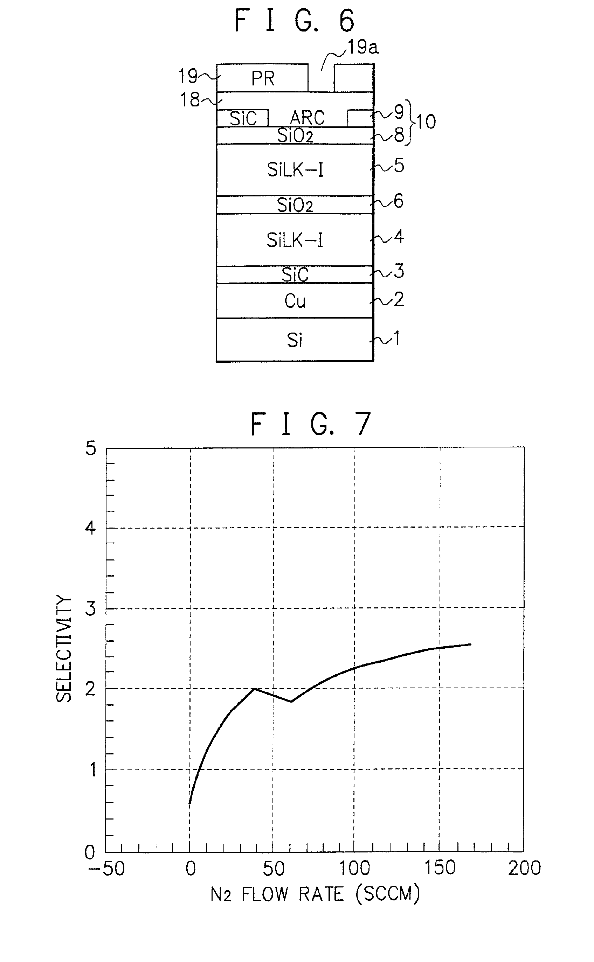

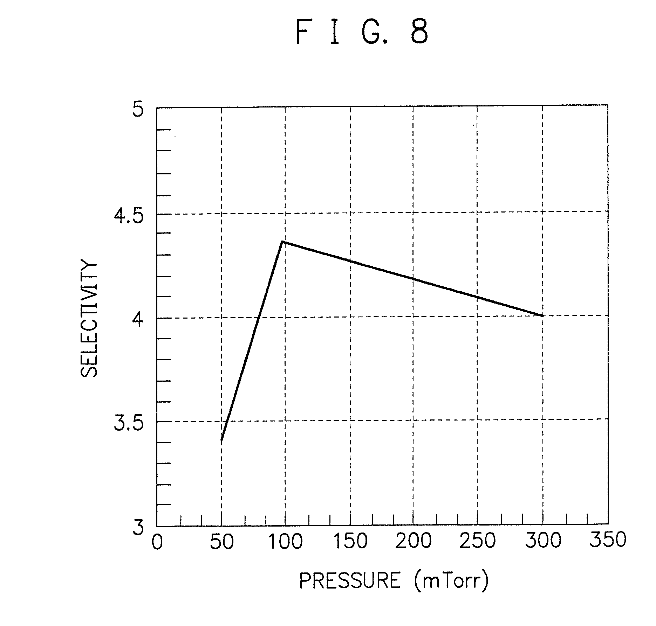

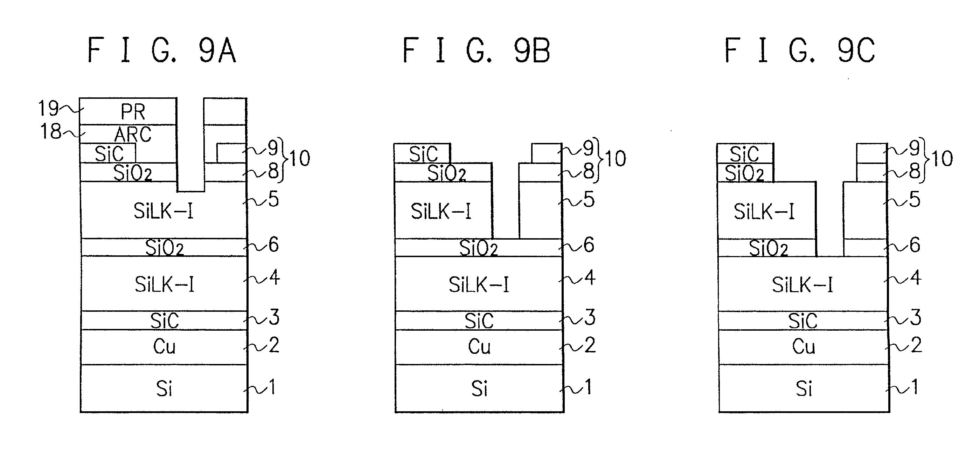

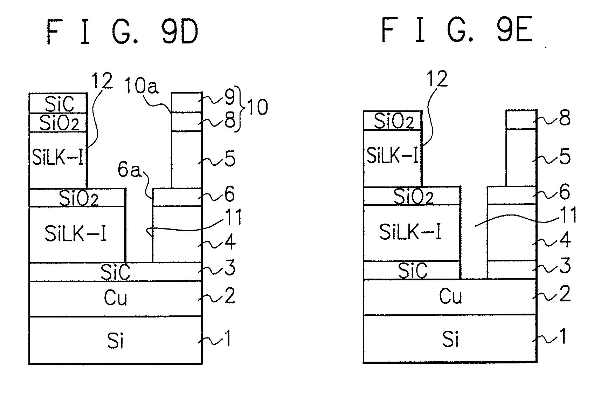

Fig. 3 is a cross sectional view showing a structure of a semiconductor device according to the first embodiment of the present invention. Fig. 4 is a cross sectional view showing an initial structure for forming a dual hard mask used in the semiconductor device. Figs. 5A through 5C are process diagrams showing processes for forming a trench mask employed for forming the dual hard mask used in the semiconductor device in sequence. Fig. 6 is a cross sectional view showing the dual hard mask used in the semiconductor device. Fig. 7 is a graph showing a relationship between a flow rate (horizontal axis) of N₂ that is one of the components of etching gas used when forming the dual hard mask and a selectivity ratio (of etching rate) (vertical axis). Fig. 8 is a graph showing a relationship between pressure (horizontal axis) in atmosphere in etching executed when forming the dual hard mask and a selectivity ratio (vertical axis). Figs. 9A through 9E are process diagrams showing processes for manufacturing the semiconductor device in sequence.

The semiconductor device according to this embodiment has the structure as shown in Fig. 3. To be concrete, first, an underlayer wiring 2 of Cu is formed on a semiconductor substrate 1 of Si in/on which predetermined elements are formed (not shown). On the underlayer wiring 2, a via interlayer insulating film (layer) (first interlayer insulating film) 4 and a wiring interlayer insulating film (second interlayer insulating film) 5, each of which is made of an organic coating of 250 to 350 nm having low permittivity and is known as, for example, SiLK (silicon low-K polymer), preferably SiLK-I®, are stacked in layers with a cap film 3 made of SiC (silicon carbide) film 18 to 25 nm in thickness and a stopper film 6 made of SiO₂ (silicon dioxide) film 20 to 30 nm in thickness between each of them, respectively. The wiring interlayer insulating film 5 is covered by a hard mask 7 made of a SiO₂ film 80 to 120 nm in thickness. The SiLK organic film has permittivity of 2.0 to 3.0, which is a fraction of those of the SiO₂ film and the SiN film conventionally used in general. While in the initial structure the hard mask 7 is formed as a dual hard mask composed of a SiO₂ film (a lower film) and a SiC film (an upper film) in layers as described above, the SiC film is etched away to end up with the hard mask 7 of the single SiO₂ film. Moreover, there exists good (etching) selectivity between the SiC film as the upper film of the dual hard mask and the SiO₂ film as the lower film thereof, and between the SiC film and the other organic films. That is, the SiC film can be selectively etched away while leaving the SiO₂ film and other organic films thereunder, or act as a mask for selectively etching the other organic films while leaving the SiC film.

Moreover, a via hole 11 is formed through the via interlayer insulating film 4 and the films on the both sides (the cap film 3 and the stopper film 6) to expose the underlayer wiring 2. A wiring trench 12 is formed through the wiring interlayer insulating film 5 and the hard mask 7 stacked thereon, and linked to the via hole 11. In the via hole 11 and the wiring trench 12, a via plug 13 and an upperlayer wiring 14 both of which are made of Cu are simultaneously formed. With this structure, there is obtained a dual damascene wiring structure in which the underlayer wiring 2 and the upperlayer wiring 14 are coupled to each other through the via plug 13.

The cap film 3 covers the underlayer wiring 2 to serve as a barrier for preventing Cu that makes up the via plug 13 and the upperlayer wiring 14 from spreading downward, or as an etching stopper in etching processes during manufacturing time. Incidentally, while the stopper film 6 lying between the via interlayer insulating film 4 and the wiring interlayer insulating film 5 has a function for stable etching during manufacture, the film 6 may not be necessarily formed.

In the aforementioned semiconductor device having the dual damascene structure, the via interlayer insulating film 4 and the wiring interlayer insulating film 5 through which the via plug 13 and the upperlayer wiring 14 are formed, respectively, are made of organic films each having low permittivity 2 to 3. Thereby, compared to the prior art employing the SiO₂ film, the SiN film, etc., it becomes possible to reduce the inter-wiring capacitance arising from the interlayer insulating films. Consequently, the signal delay is largely suppressed and the influence on the fast operation can be reduced. Moreover, the wiring interlayer insulating film 5 through which the upperlayer wiring 14 is made is covered by the hard mask 7 of the SiO₂ film. The hard mask 7 is made of a hard insulating film, thereby preventing edge defects of the mask and thus enabling stable performance. For example, it becomes possible to realize dual damascene fabrication with a design rule equal to or less than 0.2 µ m.

To manufacture the semiconductor device in this example, there is a need to prepare the dual hard mask in advance. In the following, an explanation will be given of a method for forming the dual hard mask.

First, the initial structure as shown in Fig. 4 is formed with the semiconductor substrate 1 made of Si, in/on which predetermined elements are formed (not shown). To obtain the initial structure, first, there are stacked on the semiconductor substrate 1 the underlayer wiring 2, the cap film 3, the via interlayer insulating film 4, the stopper film 6, the wiring interlayer insulating film 5, a dual hard mask 10, and an ARC (anti-reflective-coat) film 16 in this order. The underlayer wiring 2 is made of Cu. The cap film 3 is made of the SiC film 18 to 25 nm thick. The via interlayer insulating film 4 is made of the SiLK organic film 250 to 350 nm thick. The stopper film 6 is made of the SiO₂ film 20 to 30 nm thick. The wiring interlayer insulating film 5 is made of the SiLK organic film 250 to 350 nm thick. The dual hard mask 10 is made of the SiO₂ film 8 from 80 to 120 nm thick as the lower film and the SiC film 9 from 60 to 80 nm thick as the upper film stacked in this order. The ARC film 16 from 0.8 to 1.0 µm thick is formed on the SiC film 9. Subsequently, the ARC film 16 is coated with PR (photo-resist) and the PR is exposed and developed to obtain a PR film 17 having an opening 17a in the desired wiring form. The cap film 3, the via interlayer insulating film 4, the stopper film 6, the wiring interlayer insulating film 5, the dual hard mask 10, etc. are formed by a CVD (chemical vapor deposition) method, a spin-coating method, etc. so as to be thicker than a predetermined thickness, subsequently being adjusted to predetermined thickness by the CMP method.

Subsequently, a trench mask is formed on the basis of the above-mentioned initial structure. To obtain the trench mask, first, as shown in Fig. 5A, the ARC film 16 is selectively etched by a dry etching method with etching gas including CF₄, Ar, and O₂ or the like exploiting the PR film 17 as a mask. Subsequently, as shown in Fig. 5B, the SiC film 9 is selectively etched with etching gas including CF₄, Ar, 0₂, and N₂ utilizing the remaining PR film 17 as a mask. In this etching, the flow rates of CF₄, O₂, and N₂ are set in the ranges of 20 to 40 SCCM (standard cubic centimeters per minute), 10 to 50 SCCM, and 80 to 150 SCCM, respectively. In addition, the atmosphere at this etching is set to 10 to 100 mTorr (mili Torr). Hereat, if the values of the components of the etching gas are set beyond the aforementioned ranges, the selectivity between the SiC film 9 and the SiO₂ film 8 is lessened (the selectivity ratio therebetween goes down), thus failing to selectively etch only the SiC film 9.

Fig. 7 is a graph showing a relationship between the flow rate (horizontal axis) of N₂, which is one of the components of the etching gas used when selectively etching the SiC film 9, and the (etching) selectivity ratio (vertical axis) between the SiC film 9 and the SiO₂ film 8. Namely, Fig. 7 shows dependency of the selectivity ratio on the flow ratio of N₂. As shown in Fig. 7, when employing such etching gas as described above, the selectivity ratio depends on the flow ratio of N₂. Moreover, Fig. 8 is a graph showing a relationship between the pressure (horizontal axis) in the atmosphere of etching and the selectivity ratio (vertical axis) between the SiC film 9 and the SiO₂ film 8. Namely, Fig. 8 shows dependency of the selectivity ratio on the pressure. As seen in Figs. 7 and 8, it is apparent that the selectivity ratio can be determined according to the flow rate of the etching gas N₂ and/or the pressure at etching.

Thereafter, as shown in Fig. 5C, ashing is executed to the PR film 17 by plasma including O₂, or NH₃, or N₂ and H₂, or the like to remove the film 17. Subsequently, the resist residue is completely eliminated by using organic solvent, thus obtaining the hard mask, in other words, the trench mask having an opening 9a with the desired wiring shape in the SiC film 9.

Then, the dual hard mask as shown in Fig. 6 is formed on the basis of the trench mask. To obtain the dual hard mask, after forming an ARC film 18 all over the surfaces of the SiC film 9 and the opening 9a (the SiO₂ film 8), the ARC film 18 is coated with PR and the PR is exposed and developed to obtain a PR film 19 having an opening 19a, which corresponds to a via hole described later. By this means, there is formed the dual hard mask 10 composed of the SiO₂ film 8 as a lower film and the SiC film 9 as an upper film.

In the following, an explanation is given of a method for manufacturing the semiconductor device according to this embodiment by using the dual hard mask in reference to Figs. 9A to 9E. Incidentally, the following processes are continuously executed in the same etching device.

First, as shown in Fig. 9A, the ARC film 18, the dual hard mask 10 composed of the SiC film 9 and the SiO₂ film 8, and a part of the wiring interlayer insulating film 5 are selectively etched with etching gas including CF₄, Ar, O₂, and N₂ or the like utilizing the PR film 19 as a mask.

Secondly, as shown in Fig. 9B, the wiring interlayer insulating film 5 is selectively etched until the stopper film 6 is exposed with etching gas including N₂ and H₂, NH₃, NH₃ and N₂, N₂ and O₂, or the like. The etching is executed under the pressure condition where the pressure is set to approximately 300 mTorr or less to reduce difference in dimensions between trenches, etc. lying in trench-dense and trench-sparse areas and to prevent the emergence of bowing of side walls of the trenches, holes, etc. Moreover, to completely etch away the PR film 19 and the ARC film 18, it is preferable to increase pressure up to approximately 300 mTorr or more than 300 mTorr.

Thirdly, as shown in Fig. 9C, the exposed stopper film (SiO₂ film) 6 and SiO₂ film 8 as the lower film of the dual hard mask 10 are simultaneously and selectively etched with etching gas including C₄F₄, Ar, and O₂, or the like. Hereat, the SiC film 9 as the upper film is not etched because the selectivity ratio (etching resistivity of the SiC film 9) between the SiC film 9 and the SiO₂ films 8, and between the film 9 and the SiO₂ film 6 is large. Moreover at this etching, it is preferable to set the pressure to approximately 20 mTorr or less than 20 mTorr to increase aeolotropic of ion.

Fourthly, as shown in Fig. 9D, the exposed wiring interlayer insulating film 5 and via interlayer insulating film 4 are simultaneously and selectively etched with etching gas including N₂ and H₂, NH₃, NH₃ and N₂, N₂ and O₂, or the like in the pressure set to approximately 100 mTorr or less than 100 mTorr utilizing the dual hard mask 10 as a mask. Consequently, a via hole 11 and a wiring trench 12 are simultaneously formed through the via interlayer insulating film 4 and the wiring interlayer insulating film 5, respectively. The width of the wiring trench 12 depends on the width of the opening 10a (9a) of the dual hard mask 10, thereby being formed wider than the width of the via hole 11 that depends on the width of the opening 6a of the stopper film 6. When simultaneously etching two trenches each having different width by this means, the residue of the etching is apt to be left in the wider wiring trench 12. Therefore, over etching by approximately 50 % or more than 50 % is executed by increasing the pressure up to approximately 300 mTorr or more than 300 mTorr in the process of the etching to prevent the residue of the etching from being left.

Fifthly, as shown in Fig. 5E, with etching gas including CH₂F₂, Ar, O₂, and N₂, or the like, the SiC film 9 as the upper film of the dual hard mask 10 is etched, and concurrently, the cap film (SiC) film 3 is selectively etched. Subsequently, after forming a Cu film all over the surfaces by a sputtering method (to fill the via hole 11 and the wiring trench 12), unnecessary part of the Cu film on the SiO₂ film 8 is removed by the CMP method to leave the Cu (film) only in the wiring trench 12 and the via hole 11, thus simultaneously obtaining the upperlayer wiring 14 and the via plug 13 as shown in Fig. 3. By this means, the semiconductor device as shown in Fig. 3 is completed.

According to the method for manufacturing the semiconductor device as described above, the dual damascene wiring structure is obtained by using the dual hard mask 10 having less edge defects. Thereby, it becomes possible to realize higher fabricating precision suitable for miniaturization, thus enabling dual damascene fabrication under a design rule of, for example, 0.2 µm or less.

As described above, in the structure of the semiconductor device according to the first embodiment, the via interlayer insulating film 4 and the wiring interlayer insulating film 5 through which the via plug 13 and the upperlayer wiring 14 are formed, respectively, are made of organic materials having low permittivity, and moreover, the wiring interlayer insulating film 5 is covered by the hard mask 7 made of the SiO₂ film 8. Therefore, the capacitance arising from the interlayer insulating films can be reduced, thus enabling the signal delay to be suppressed and the influence on the high-speed performance to be reduced. Further, the edge defects of the mask are reduced, thus enabling stable performance.

Moreover, the dual hard mask 10 having less edge defects of the mask is formed on the second interlayer insulating film 5. After the via hole 11 and the wiring trench 12 are simultaneously formed through the via interlayer insulating film 4 and the wiring interlayer insulating film 5, respectively, both made of organic films having low permittivity by the use of the dual hard mask 10, the via plug 13 and the upperlayer wiring 14 are simultaneously formed in the via hole 11 and the wiring trench 12, respectively. Thereby, it becomes possible to easily build the dual damascene structure with higher fabricating precision.

Accordingly, it becomes possible to reduce inter-wiring capacitance arising from the interlayer insulating films and to realize the dual damascene wiring structure with high precision.

### [Second Embodiment]

A semiconductor device according to the second embodiment of the present invention differs from that in the first embodiment in that another thin film is employed for the upper film of the dual hard mask.

In this embodiment, as a substitute for the SiC film 9 as the upper film of the dual hard mask 10 shown in Fig. 6 in the first embodiment, there is employed a film made of inorganic material having low permittivity such as HSQ (hydrogen-silsesquioxane), MSQ (methyl-silsesquioxane), or MHSQ (methyl-hydrogen-silsesquioxane), or the like each including SiN, SiCN, W, WSi, SiOF, and/or siloxane as a component(s). Such inorganic film has the function similar to that of the SiC film used in the first embodiment. Consequently, the structure in this embodiment brings the same effects as in the first embodiment.

### [Third Embodiment]

A semiconductor device according to the third embodiment of the present invention differs from that in the first embodiment in that another thin film is employed for the lower film of the dual hard mask.

In this embodiment, as a substitute for the SiO₂ film 8 as the lower film of the dual hard mask 10 shown in Fig. 6 in the first embodiment, there is employed a film made of inorganic material having low permittivity such as HSQ, MSQ, MHSQ, or the like each including SiC, SiN, SiCN, W, WSi, SiOF, and/or siloxane as a component(s). Such inorganic film has the function similar to that of the SiO₂ film used in the first embodiment. Consequently, the structure in this embodiment brings the same effects as in the first embodiment.

### [Fourth Embodiment]

A semiconductor device according to the fourth embodiment of the present invention differs from that in the first embodiment in that another thin film is employed for the stopper film formed in between the via interlayer insulating film and the wiring interlayer insulating film.

In this embodiment, as a substitute for the stopper film 6 of the SiO₂ film formed in between the via interlayer insulating film 4 and the wiring interlayer insulating film 5 shown in Fig. 6 in the first embodiment, there is employed a film made of inorganic material having low permittivity such as HSQ, MSQ, MHSQ, or the like each including SiN, SiCN, SiC, SiOF, and/or siloxane as a component(s). Such inorganic film has the function similar to that of the SiO₂ film used in the first embodiment. Consequently, the structure in this embodiment brings the same effects as in the first embodiment.

### [Fifth Embodiment]

A semiconductor device according to the fifth embodiment of the present invention differs from that in the first embodiment in that another thin film is employed for the cap film.

In this embodiment, a thin film such as SiON, SiO₂, SiCN, SiN, or the like is employed as a substitute for the cap film 3 of the SiC film formed on the underlayer wiring 2 shown in Fig. 6 in the first embodiment. Such thin film has the function similar to that of the SiO₂ film used in the first embodiment.

When using SiO₂ film for the cap film 3, it is preferable to employ etching gas including C₄F₄, CO, Ar, and O₂, C₄F₈, C₅F₈, CHF₃, or the like. By using such etching gas, it becomes possible to increase etching rate and to reduce the edge defects of the mask.

Consequently, the structure in this embodiment brings the same effects as in the first embodiment.

### [Sixth Embodiment]

A semiconductor device according to the sixth embodiment of the present invention differs from that in the first embodiment in that there is employed a dual hard mask obtained by combining the second and third embodiments.

In this embodiment, as a substitute for the SiC film 9 as the upper film of the dual hard mask 10 shown in Fig. 6 in the first embodiment, there is employed a film made of an inorganic material having low permittivity such as HSQ, MSQ, MHSQ or the like each having SiN, SiCN, W, WSi, SiOF, and/or siloxane as a component(s). Moreover, in place of the SiO₂ film 8 as the lower film of the dual hard mask 10, a film made of an inorganic material having low permittivity such as HSQ, MSQ, MHSQ or the like including SiC, SiN, SiCN, W, WSi, SiOF, and/or siloxane as a component(s).

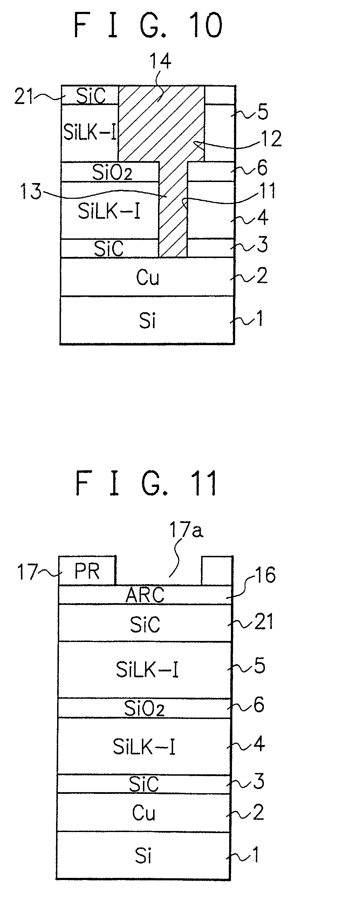

In the following, an explanation is given of the semiconductor device and the manufacturing method thereof according to this embodiment in reference to Figs. 10 to 14 correspondingly to Figs. 3 to 6 and 9. Incidentally, in the following explanation, there is cited an example in which one and the same insulating film is employed for the lower film and the upper film.

As shown in Fig. 10, the semiconductor device according to this embodiment has the same structure as that in the first embodiment except that the wiring interlayer insulating film 5 is covered by a hard mask 21 composed of a SiC film, which serves as the combination of the lower film and the upper film. Therefore, the same reference numbers as those in Fig. 3 represent the same parts in Fig. 10, and thereby, the explanation is abbreviated.

To manufacture the semiconductor device according to this embodiment, it is necessary to prepare in advance a dual hard mask (the mask is made of a single insulating film of the SiC film, thereby hereinafter referred to as a "hard mask" simply). In the following, an explanation is given of a method for forming the hard mask.

First, as a substitute for the stacked films of the SiO₂ film 8 as the lower film and the SiC film 9 as the upper film shown in Fig. 4 in the first embodiment, the hard mask 21 of the SiC film is used to form the initial structure as shown in Fig. 11.

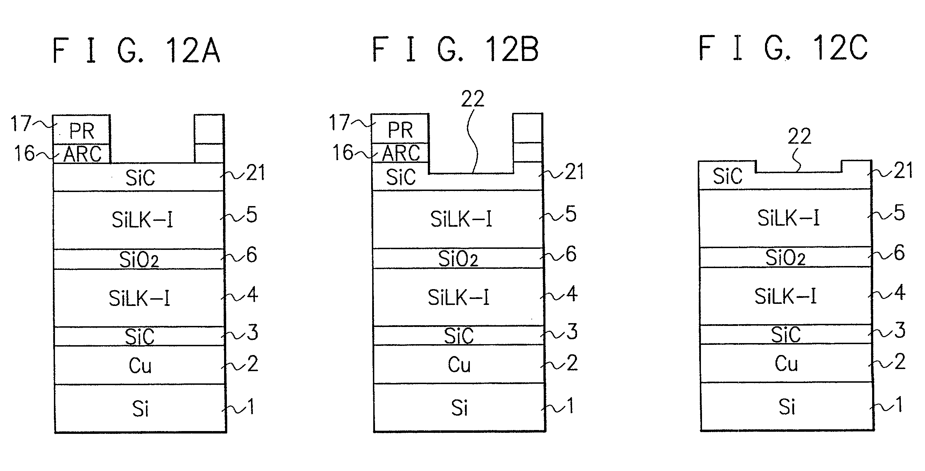

Thereafter, a trench mask is formed on the basis of the aforementioned initial structure. To obtain the trench mask, first, as shown in Fig. 12A, the ARC film 16 is selectively etched by the dry etching method with etching gas including CF₄, Ar, and O₂, or the like utilizing the PR film 17 as a mask. Subsequently, as shown in Fig. 12B, the hard mask 21 is selectively etched with etching gas including CF₄, Ar, O₂, and N₂ by approximately half as much as the thickness thereof with the use of the remaining PR film 17 as a mask, thus obtaining a concave section 22.

Thereafter, as shown in Fig. 12C, after the PR film 17 is removed by ashing with plasma including O₂, NH₃, N₂ and H₂, or the like, the resist residue is completely eliminated with the use of organic solvent to obtain the hard mask, namely, the trench mask having the concave section 22.

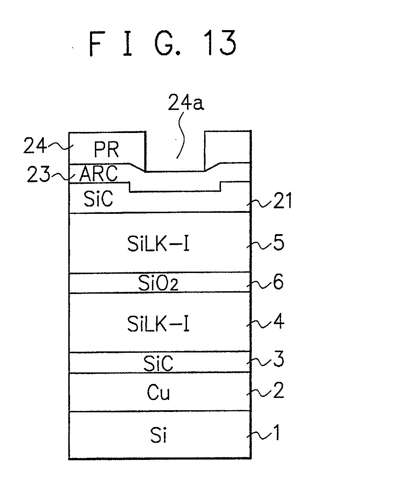

Subsequently, on the basis of the trench mask, there is formed the hard mask 21 that corresponds to the dual hard mask 10 in the first embodiment as shown in Fig. 13. To obtain the hard mask 21, after an ARC film 23 is formed all over the surfaces of the hard mask 21 and the concave section 22, the ARC film 23 is coated with PR and the PR is exposed and developed to form a PR film 24 having an opening 24a that corresponds to a via hole described later. By this means, the hard mask 21 made of the SiC film is obtained.

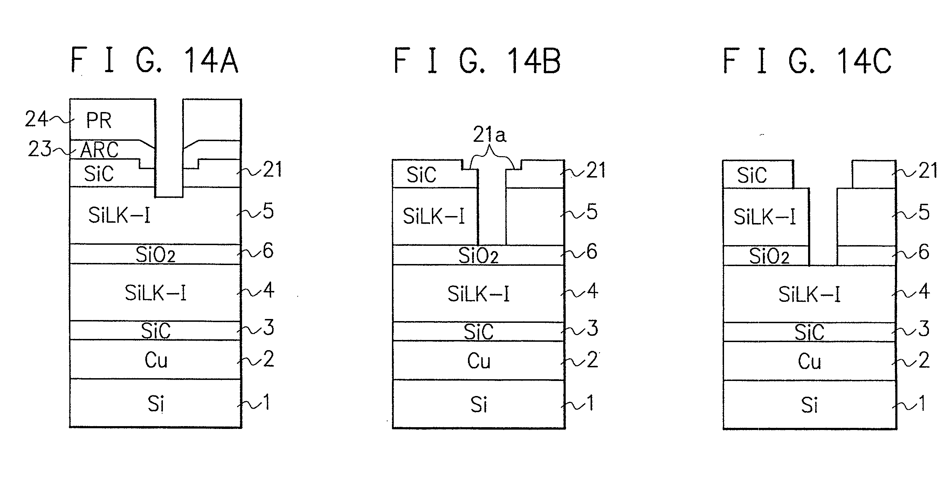

In the following, an explanation is given of a method for manufacturing the semiconductor device according to this embodiment with the use of the above-described hard mask referring to Figs. 14A to 14E. Incidentally, the following processes are continuously executed in the same etching device.

First, as shown in Fig. 14A, the ARC film 23, the hard mask 21, and a part of the wiring interlayer insulating film 5 are selectively etched with etching gas including CF₄, Ar, O₂, and N₂, or the like utilizing the PR film 24 as a mask.

Secondly, as shown in Fig. 14B, the wiring interlayer insulating film 5 is selectively etched with etching gas including N₂ and H₂, NH₃, NH₃ and N₂, N₂ and O₂, or the like until the stopper film 6 is exposed. At this etching, the PR film 24 and the ARC film 23 are removed in the same manner as shown in the first embodiment.

Thirdly, as shown in Fig. 14C, the exposed stopper film (SiO₂ film) 6 and a section 21a, which is protruded in inward direction as shown in Fig. 14B, are simultaneously and selectively etched with etching gas including CH₂F₂, Ar, and O₂, or the like.

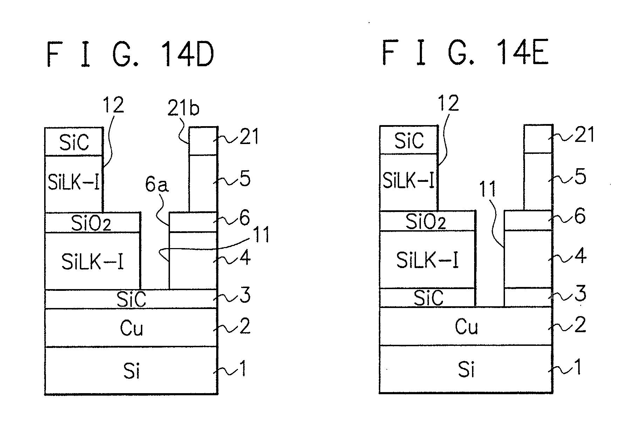

Fourthly, as shown in Fig. 14D, the exposed wiring interlayer insulating film 5 and via interlayer insulating film 4 are simultaneously and selectively etched with etching gas including N₂ and H₂, NH₃, NH₃ and N₂, N₂ and O₂, or the like utilizing the hard mask 21 as a mask. Consequently, the via hole 11 and the wiring trench 12 are formed through the via interlayer insulating film 4 and the wiring interlayer insulating film 5, respectively. The width of the wiring trench 12 depends on the width of an opening 21b (the concave section 22 shown in Fig. 12C) in the hard mask 21, thus being formed wider than the width of the via hole 11 that depends on the width of the opening 6a in the stopper film 6.

Fifthly, as shown in Fig. 14E, with etching gas including CH₂F₂, Ar, O₂, and N₂, or the like, the cap film (SiC film) 3 is selectively etched, and simultaneously, the surface of the hard mask (SiC film) 21 is etched.

Lastly, after forming a Cu film on all over the surfaces by the sputtering method (and filling the via hole 11 and the wiring trench 12 with Cu), unnecessary part of the Cu film on the hard mask 21 is removed to leave the Cu (film) only in the wiring trench 12 and the via hole 11, thus simultaneously obtaining the upperlayer wiring 14 and the via plug 13. By this means, the semiconductor device as shown in Fig. 10 is completed.

As described above, the semiconductor device according to this embodiment has the same configuration as that in the first embodiment except that the dual hard mask is replaced with the hard mask. Thereby, the same effects as those described in the first embodiment can be obtained.

### [Seventh Embodiment]

In a semiconductor device according to the seventh embodiment of the present invention, the via interlayer insulating film (the first interlayer insulating film) and the wiring interlayer insulating film (the second interlayer insulating film) used in the semiconductor device according to the first embodiment are evened by the CMP method.

In other words, in the semiconductor device in this embodiment, the surfaces of the via interlayer insulating film 4 and the wiring interlayer insulating film 5 are flattened by the CMP method so as to eliminate every irregularity generated when each interlayer insulating films is stacked. Consequently, it becomes possible to prevent the occurrence of a problem, for example, that wiring formed through each interlayer insulating film is disconnected owing to the irregularities.

To manufacture such semiconductor device, at the time of forming the initial structure as shown in Fig. 4, the via interlayer insulating film 4 made of the SiLK organic film is formed by the CVD method, the spin-coating method, or the like. Subsequently, the thickness of the film 4 is adjusted to predetermined thickness by the CMP method. Then, after forming the stopper film 6 of the SiO₂ film in predetermined thickness, the wiring interlayer insulating film 5 made of the SiLK organic film is formed by the CVD method, the spin-coating method, or the like. Thereafter, the thickness of the film 5 is adjusted to predetermined film thickness by the CMP method.

As described above, according to this embodiment, the interlayer insulating films are evened by the CMP method after the films are stacked. Thereby, it becomes possible to eliminate every irregularity generated when each interlayer insulating film is stacked.

### [Eighth Embodiment]

In a semiconductor device according to the eighth aspect of the present invention, the stopper film formed in between the via interlayer insulating film (the first interlayer insulating film) and the wiring interlayer insulating film (the second interlayer insulating film) in the semiconductor device according to the first embodiment is evened by the CMP method.

Namely, in the semiconductor device in this embodiment, the surface of the stopper film 6 shown in Fig. 3 in the first embodiment formed in between the via interlayer insulating film 4 and the wiring interlayer insulating film 5 is flattened by the CMP method so as to eliminate every irregularity generated when the stopper film (and the interlayer insulating film(s)) is stacked. By this means, the occurrence of a problem of disconnection of wiring formed through each interlayer insulating film owing to the irregularities, etc. can be prevented.

To manufacture such semiconductor device, at the time of forming the initial structure as shown in Fig. 4, first, the via interlayer insulating film 4 made of the SiLK organic film is formed by the CVD method, the spin-coating method, or the like. Then, the thickness of the film 4 is adjusted to predetermined thickness. Subsequently, the stopper film (SiO₂ film) 6 is formed by the CVD method, or the like, and the thickness thereof is adjusted to predetermined film thickness.

Consequently, the structure according to this embodiment brings the same effects as those described in the seventh embodiment.

### [Ninth Embodiment]

A semiconductor device according to the ninth embodiment of the present invention differs from that in the first embodiment in that the process to form the stopper film formed in between the via interlayer insulating film and the wiring interlayer insulating film is skipped.

In other words, according to this embodiment, the stopper film 6 formed in between the via interlayer insulating film 4 and the wiring interlayer insulating film 5 shown in Fig. 6 in the first embodiment is omitted to form a single interlayer insulating film serving as the films 4 and 5.

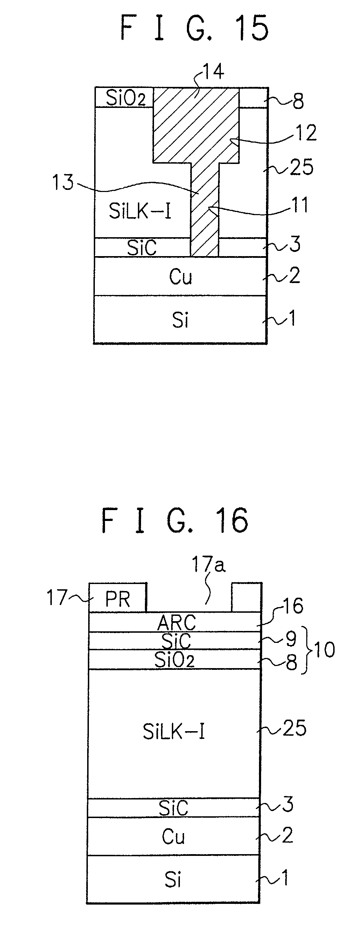

In the following, an explanation will be given of the semiconductor device and the method for manufacturing the same according to this embodiment referring to Figs. 15 to 19 correspondingly to Figs. 3 to 6 and 9 in the first embodiment.

As shown in Fig. 15, the semiconductor device according to this embodiment includes an interlayer insulating film 25 formed on the underlayer wiring 2 with the cap film 3 between them. The interlayer insulating film 25 is made of an organic film 500 to 700 nm thick having low permittivity, and serves as the via interlayer insulating film and the wiring interlayer insulating film. In this embodiment, the organic material having low permittivity such as SiLK is employed for the film 25 as with the first embodiment.

To manufacture the semiconductor device according to this embodiment, it is necessary to prepare in advance a dual hard mask. The following is an explanation of forming the dual hard mask used in this embodiment.

First, an initial structure as shown in Fig. 16 is formed with the use of the interlayer insulating film 25 made of the organic film having low permittivity, which serves as the via interlayer insulating film 4 and the wiring interlayer insulating film 5 shown in Fig. 4 in the first embodiment.

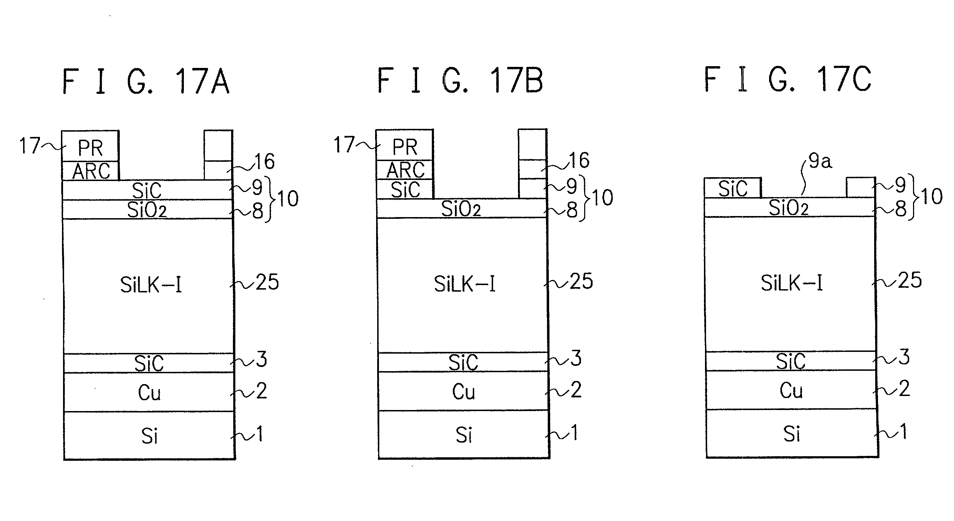

Subsequently, a trench mask is formed on the basis of the above-described initial structure. To form the trench mask, as shown in Fig. 17A, the ARC film 16 is selectively etched by the dry etching method with etching gas including CF₄, Ar, and O₂, or the like utilizing the PR film 17 as a mask. Thereafter, as shown in Fig. 17B, the SiC film 9 of the upper film is selectively etched with etching gas including CF₄, Ar, O₂, and N₂ utilizing the remaining PR film 17 as a mask in the same manner.

Subsequently, as shown in Fig. 17C, after the PR film 17 is removed by ashing with plasma including O₂, NH₃, N₂ and H₂, or the like, the resist residue is completely removed with the use of organic solvent. By this means, the hard mask, namely, the trench mask having an opening 9a is obtained.

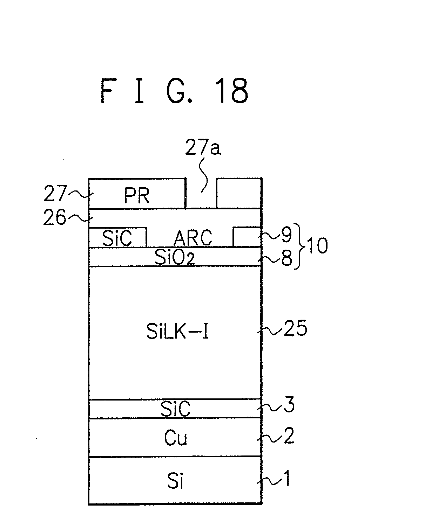

Thereafter, the dual hard mask as shown in Fig. 18 is formed on the basis of the trench mask. To obtain the dual hard mask, after an ARC film 26 is formed all over the surfaces of the upper film 9 and the lower film 8 (the opening 9a), the ARC film 26 is coated with PR and the PR is exposed and developed to form a PR film 27 having an opening 27a that corresponds to a via hole described later. By this means, the dual hard mask 10 can be obtained.

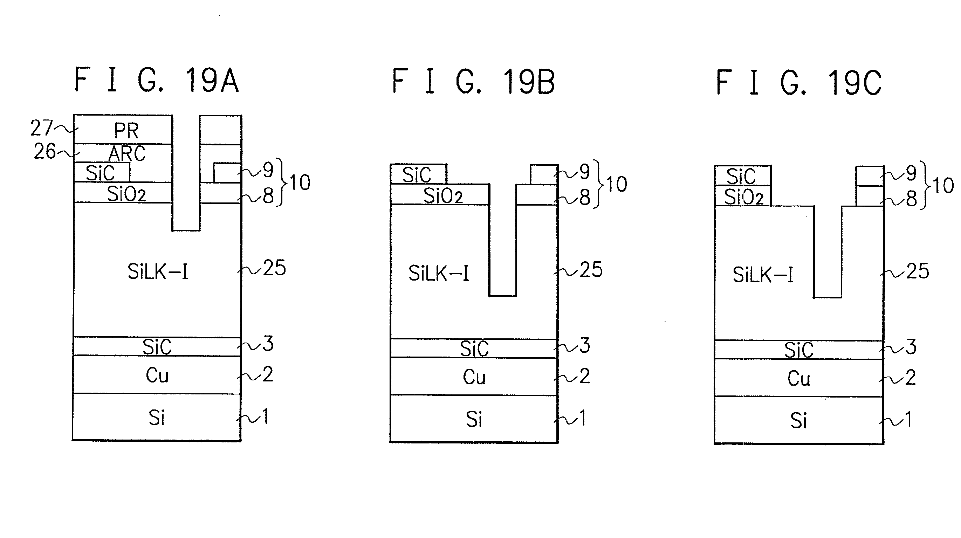

In the following, an explanation is given of a manufacturing method for the semiconductor device with the use of the dual hard mask according to this embodiment referring to Figs. 19A to 19E. Incidentally, the following processes are continuously executed in the same etching device.

First, as shown in Fig. 19A, the ARC film 26, the dual hard mask 10 made of the SiC film 9 and the SiO₂ film 8, and a part of the interlayer insulating film 25 are selectively etched with etching gas including CF₄, Ar, O₂, and N₂, or the like utilizing the PR film 27 as a mask.

Secondly, as shown in Fig. 19B, the part of the interlayer insulating film 25 is selectively etched more deeply with etching gas including N₂ and H₂, NH₃, NH₃ and N₂, N₂ and O₂, or the like. In this etching, the PR film 27 and the ARC film 26 are completely etched or eliminated in the same manner as described in the first embodiment.

Thirdly, as shown in Fig. 19C, the exposed SiO₂ film 8 is selectively etched with etching gas including C₄F₄, Ar, and O₂, or the like utilizing the SiC film 9 as a mask.

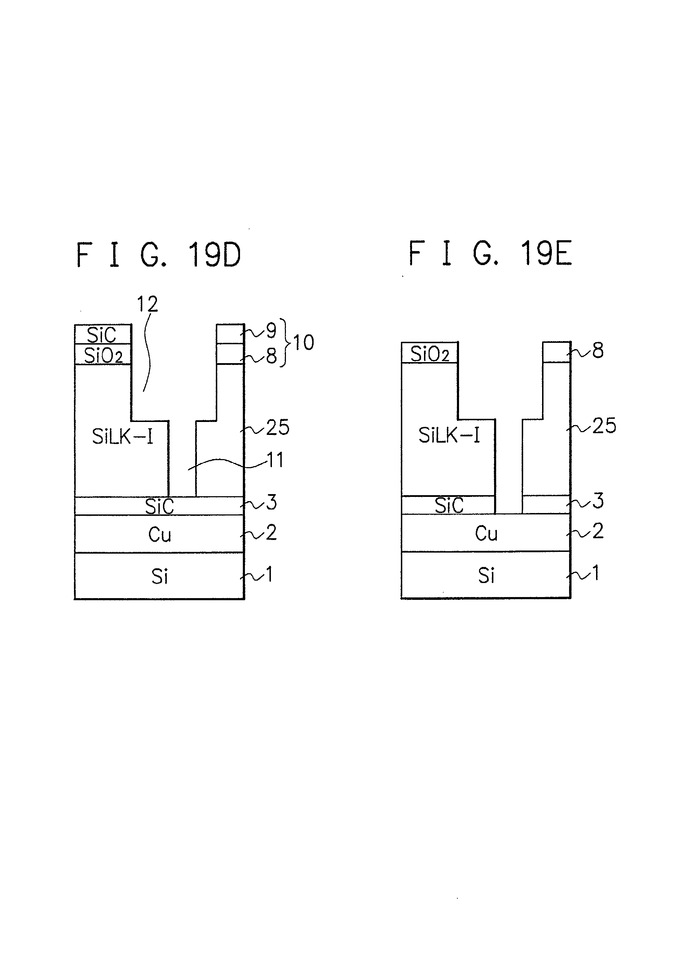

Fourthly, as shown in Fig. 19D, the exposed interlayer insulating film 25 is selectively etched with etching gas including N₂ and H₂, NH₃, NH₃ and N₂, N₂ and O₂, or the like utilizing the dual hard mask 10 as a mask. This etching is executed simultaneously in the thickness and width directions (vertical and horizontal directions) of the interlayer insulating film 25, and accordingly, the wiring trench 12 and the via hole 11 are simultaneously formed through the interlayer insulating film 25.

Fifthly, as shown in Fig. 19E, with etching gas including CH₂F₂, Ar, O₂, and N₂, or the like, the SiC film 9 as the upper film of the dual hard mask 10 is etched, and simultaneously, the cap film (SiC film) 3 is selectively etched.

Subsequently, after forming a Cu film all over the surfaces by the sputtering method (to fill the via hole 11 and the wiring trench 12), unnecessary part of the Cu film on the SiO₂ film 8 is removed by the CMP method to leave the Cu (film) only in the wiring trench 12 and the via hole 11, thus simultaneously obtaining the upperlayer wiring 14 and the via plug 13. By this means, the semiconductor device according to this embodiment is completed as shown in Fig. 15.

Consequently, the same effects as those described in the first embodiment can be obtained.

### [Tenth Embodiment]

A semiconductor device according to the tenth embodiment of the present invention differs from that in the first embodiment in that an inorganic film and an organic film are employed for the via interlayer insulating film and the wiring interlayer insulating film, respectively.

In other words, in this embodiment, as substitutes for the via interlayer insulating film 4 and the wiring interlayer insulating film 5 used in the first embodiment shown in Fig. 6, an inorganic film 28 made of a MSQ film having low permittivity and an organic film 29 made of a SiLK film having low permittivity, respectively.

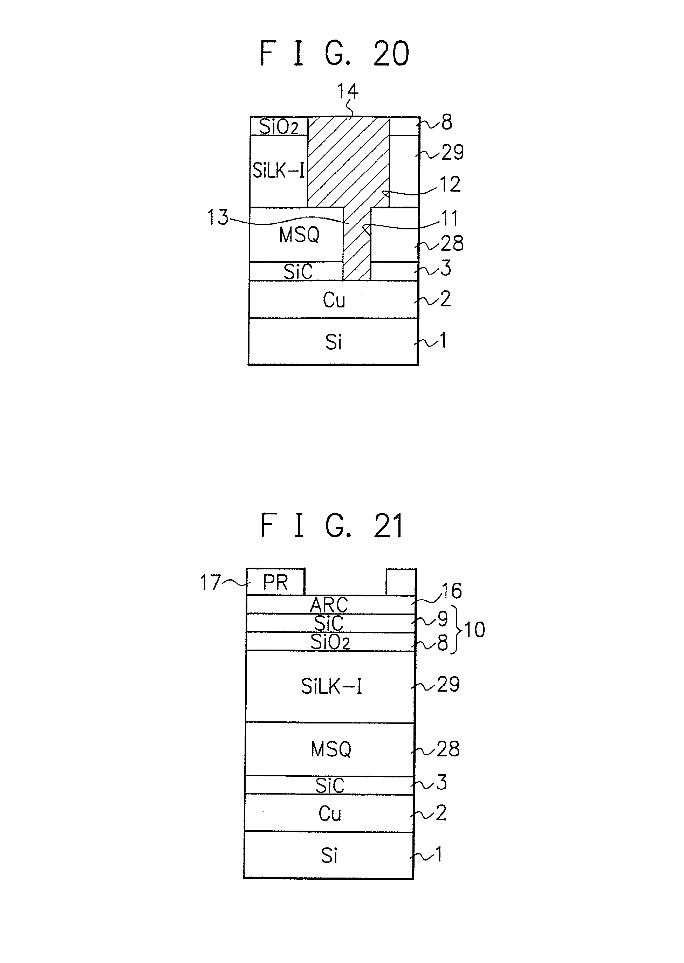

In the following, an explanation is given of the semiconductor device and a method for manufacturing the same according to this embodiment referring to Figs. 20 to 24 correspondingly to Figs. 3 to 6 and 9 in the first embodiment.

The semiconductor device according to this embodiment employs the inorganic film 28 of the MSQ film and the organic film 29 of the SiLK film both having low permittivity for the via interlayer insulating film and the wiring interlayer insulating film, respectively, as shown in Fig. 20.

To manufacture the semiconductor device according to this embodiment, it is necessary to prepare in advance a dual hard mask. The following is an explanation for forming the dual hard mask used in this embodiment.

First, the inorganic film 28 made of the MSQ film and the organic film 29 made of the SiLK film both having low permittivity are used for substitutes for the via interlayer insulating film 4 and the wiring interlayer insulating film 5 used in the first embodiment shown in Fig. 6 to form an initial structure shown in Fig. 21.

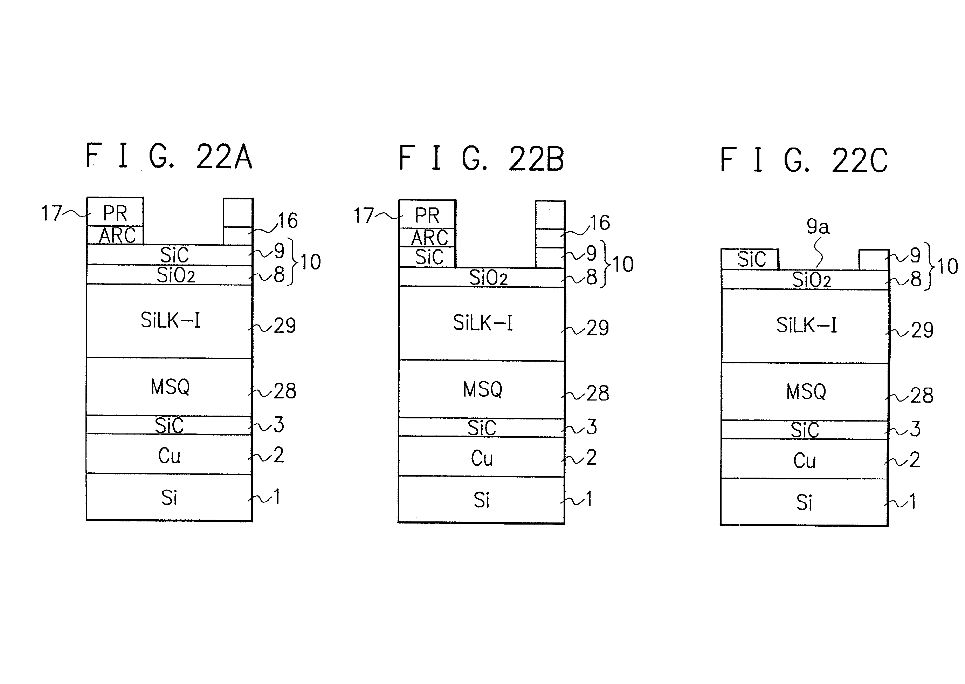

Thereafter, a trench mask is formed on the basis of the aforementioned initial structure. To obtain the trench mask, first, as shown in Fig. 22A, the ARC film 16 is selectively etched by the dry etching method with etching gas including CF₄, Ar, and O₂, or the like utilizing the PR film 17 as a mask. Subsequently, as shown in Fig. 22B, the SiC film 9 of the upper film is selectively etched with etching gas including CF₄, Ar, O₂, and N₂ utilizing the remaining PR film 17 as a mask in the same manner.

Subsequently, as shown in Fig. 22C, after the PR film 17 is removed by ashing with plasma including O₂, NH₃, N₂ and H₂, or the like, the resist residue is completely removed with the use of organic solvent. By this means, the hard mask, in other words, the trench mask having the opening 9a can be obtained.

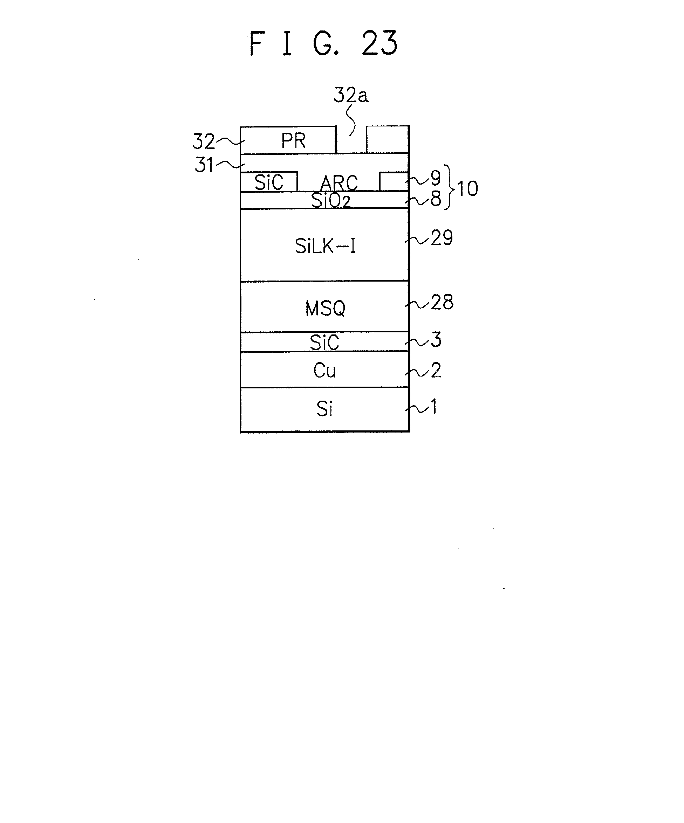

Thereafter, the dual hard mask is formed on the basis of the trench mask described above. To obtain the dual hard mask, as shown in Fig. 23, after forming an ARC film 31 all over the surfaces of the upper film 9 and the opening 9a (the lower film 8), the ARC film 31 is coated with PR and the PR is exposed and developed to form a PR film 32 having an opening 32a that corresponds to a via hole described later. By this means, the dual hard mask 10 can be obtained.

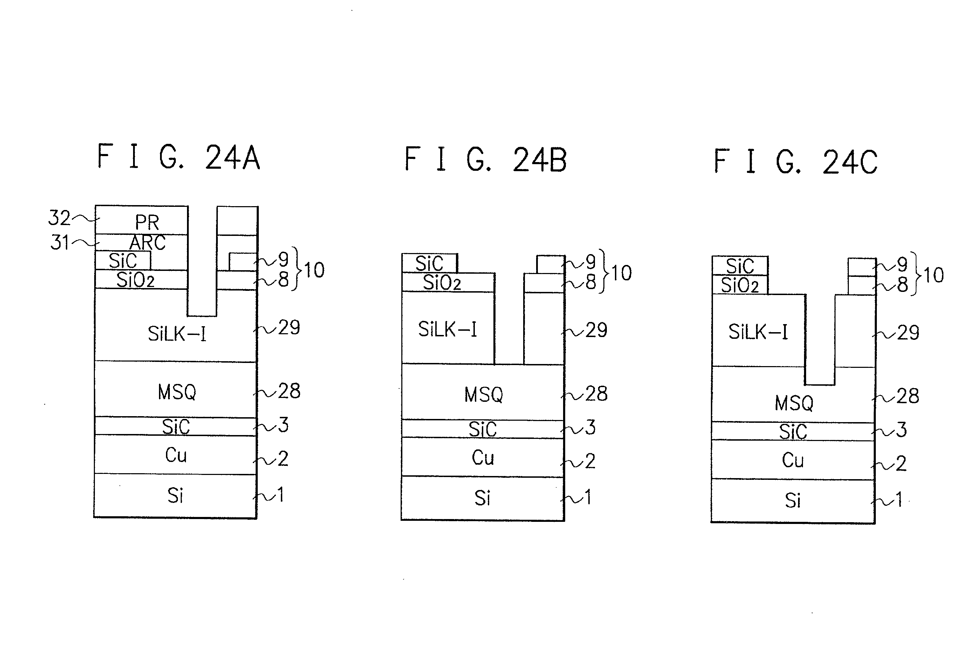

In the following, an explanation is given of a method for manufacturing the semiconductor device according to this embodiment with the use of the dual hard mask referring to Figs. 24A to 24F. Incidentally, the following processes are continuously executed in the same etching device.

First, as shown in Fig. 24A, the ARC film 31, the dual hard mask 10 made of the SiC film 9 and the SiO₂ film 8, and a part of the organic film 29 are selectively etched with etching gas including CF₄, Ar, O₂, and N₂, or the like utilizing the PR film 32 as a mask.

Secondly, as shown in Fig. 24B, the part of the organic film 29 is selectively etched more deeply with etching gas including N₂ and H₂, NH₃, NH₃ and N₂, N₂ and O₂, or the like until the inorganic film 28 is exposed. During this etching, the PR film 32 and the ARC film 31 are eliminated (etched) in the same manner as described in the first embodiment.

Thirdly, as shown in Fig. 24C, the exposed SiO₂ film 8 is selectively etched with etching gas including C₄F₄, Ar, and O₂, or the like utilizing the SiC film 9 as a mask. Simultaneously, a part of the inorganic film 28 is selectively and shallowly etched.

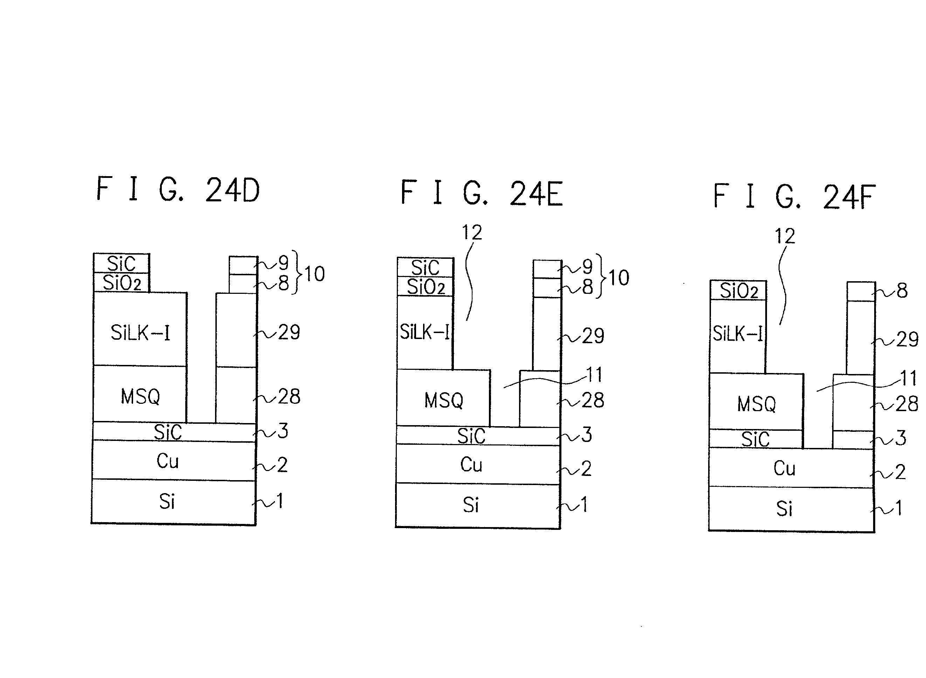

Fourthly, as shown in Fig. 24D, the part of the inorganic film 28 is selectively etched with etching gas including N₂ and H₂, NH₃, NH₃ and N₂, N₂ and O₂, or the like utilizing the dual hard mask 10 (and the organic film 29) as a mask until the cap film 3 is exposed.

Fifthly, as shown in Fig. 24E, the exposed organic film 29 is selectively etched with etching gas including N₂ and H₂, NH₃, NH₃ and N₂, N₂ and O₂, or the like utilizing the dual hard mask 10 as a mask. Consequently, the wiring trench 12 and the via hole 11 are simultaneously formed through the organic film 29 and the inorganic film 28, respectively.

Sixthly, as shown in Fig. 24F, with etching gas including CH₂F₂, Ar, O₂, and N₂, or the like, the SiC film 9 as the upper film of the dual hard mask 10 is etched, and simultaneously, the cap film (SiC film) 3 is selectively etched.

Subsequently, after a Cu film is formed all over the surfaces by the sputtering method to fill the wiring trench 12 and the via hole 11, unnecessary part of the Cu film on the SiO₂ film 8 is removed by the CMP method to leave the Cu (film) only in the wiring trench 12 and the via hole 11, thus simultaneously obtaining the upperlayer wiring 14 and the via plug 13. By this means, the semiconductor device according to this embodiment can be completed as shown in Fig. 20.

Consequently, the structure of the semiconductor device according to this embodiment brings the same effects as those obtained in the first embodiment.

While the preferred embodiments of the present invention have been explained in detail with drawings, the detail structure cannot be limited to the aforementioned embodiments. For example, as a modified example of the tenth embodiment, if employing an organic film for the via interlayer insulating film and an inorganic film for the wiring interlayer insulating film, the same effects as those described in the tenth embodiment can be obtained. Moreover, in the above description, while the Cu film is used as a material of conductive film forming the via plug that connects the underlayer wiring and the upperlayer wiring, another material such as alloy of Cu and Al, Cu and Ag, Cu and Al and Si or the like may be employed other than the Cu film. Furthermore, the value of the film thickness of each insulating film that makes up the dual damascene wiring structure is just cited as an example, and thus may be changed according to the purpose, use, and the like.

As set forth hereinbefore, in the semiconductor device according to the present invention, the interlayer insulating films through which the via plug and the upperlayer wiring are formed are made of insulating films having low permittivity and covered by the hard mask. Thereby, the inter-wiring capacitance arising from the interlayer insulating films can be reduced, thus enabling the signal delay to be suppressed and the influence on high-speed performance to be reduced. Moreover, stable performance can be realized because of the reduction of the edge defects of the mask.

Moreover, according to the method for manufacturing the semiconductor device of the present invention, the hard mask such as the dual hard mask with less mask-edge defects is formed on the interlayer insulating films. After forming the via hole and the wiring trench through the interlayer insulating films having low permittivity with the use of the hard mask, the via plug and the upperlayer wiring are simultaneously formed in the via hole and the wiring trench. Thereby, it becomes possible to easily manufacture the dual damascene wiring structure having high fabricating precision.

Consequently, it becomes possible to reduce inter-wiring capacitance arising from the interlayer insulating films and to realize the dual damascene wiring structure with high fabricating precision.

While the present invention has been described with reference to the particular illustrative embodiments, it is not to be restricted by the embodiments but only by the appended claims. It is to be appreciated that those skilled in the art can change or modify the embodiments without departing from the scope and spirit of the present invention.

## Claims

1. A semiconductor device, wherein:
an interlayer insulating film is formed over an underlayer wiring;
a via plug and an upperlayer wiring are almost simultaneously formed in a via hole and a wiring trench, respectively, that are formed through the interlayer insulating film;
the underlayer wiring and the upperlayer wiring are linked through the via plug; and
the interlayer insulating film is an insulating film having low permittivity and covered by a hard mask.

2. A semiconductor device, wherein:
an interlayer insulating film is formed over an underlayer wiring;
a via plug and an upperlayer wiring are almost simultaneously formed in a via hole and a wiring trench, respectively, that are formed through the interlayer insulating film;
the underlayer wiring and the upperlayer wiring are linked through the via plug;
the interlayer insulating film is an insulating film having low permittivity; and
the interlayer insulating film is covered by a dual hard mask in which two different kinds of materials are stacked as a lower film and an upper film.

3. A semiconductor device, wherein:
an interlayer insulating film is formed over an underlayer wiring;
a cap film is formed on the underlayer wiring;
a via plug and an upperlayer wiring are almost simultaneously formed in a via hole and a wiring trench, respectively, that are formed through the interlayer insulating film;
the underlayer wiring and the upperlayer wiring are linked through the via plug;
the interlayer insulating film is an insulating film having low permittivity; and
the interlayer insulating film is covered by a dual hard mask in which two different kinds of materials are stacked as a lower film and an upper film.

4. A semiconductor device, wherein:
a first interlayer insulating film and a second interlayer insulating film are stacked over an underlayer wiring in this order;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a hard mask.

5. A semiconductor device, wherein:
a first interlayer insulating film and a second interlayer insulating film are stacked over an underlayer wiring in this order;
a stopper film is formed in between the first interlayer insulating film and the second interlayer insulating film;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a hard mask.

6. A semiconductor device, wherein:
a first interlayer insulating film and a second interlayer insulating film are stacked over an underlayer wiring in this order;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a dual hard mask in which two different kinds of materials are stacked as a lower film and an upper film.

7. A semiconductor device, wherein:
a first interlayer insulating film and a second interlayer insulating film are stacked over an underlayer wiring in this order;
a cap film is formed on the underlayer wiring;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a hard mask.

8. A semiconductor device, wherein:
a first interlayer insulating film and a second interlayer insulating film are stacked over an underlayer wiring in this order;
a stopper film is formed in between the first interlayer insulating film and the second interlayer insulating film;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a dual hard mask in which two different kinds of materials are stacked as a lower film and an upper film.

9. A semiconductor device, wherein:
a first interlayer insulating film and a second interlayer insulating film are stacked over an underlayer wiring in this order;
a stopper film is formed in between the first interlayer insulating film and the second interlayer insulating film;
a cap film is formed on the underlayer wiring;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a hard mask.

10. A semiconductor device, wherein:
a first interlayer insulating film and a second interlayer insulating film are stacked over an underlayer wiring in this order;
a stopper film is formed in between the first interlayer insulating film and the second interlayer insulating film;
a cap film is formed on the underlayer wiring;
a via plug and an upperlayer wiring are almost simultaneously formed in a via hole and a wiring trench, respectively, that are formed through the respective first and the second interlayer insulating films;
the underlayer wiring and the upperlayer wiring are linked through the via plug;
both of the first and the second interlayer insulating films are insulating films having low permittivity; and
the second interlayer insulating film is covered by a dual hard mask in which two different kinds of materials are stacked as a lower film and an upper film.

11. The semiconductor device as claimed in claim 1, wherein the interlayer insulating film is an organic film.

12. The semiconductor device as claimed in claim 2, wherein the interlayer insulating film is an organic film.

13. The semiconductor device as claimed in claim 3, wherein the interlayer insulating film is an organic film.

14. The semiconductor device as claimed in claim 2, wherein the two different materials are employed to acquire etching selectivity between the upper film and the lower film and etching selectivity between the upper film and the interlayer insulating film disposed immediately under the lower film.

15. The semiconductor device as claimed in claim 3, wherein the two different materials are employed to acquire etching selectivity between the upper film and the lower film and etching selectivity between the upper film and the interlayer insulating film disposed immediately under the lower film.

16. The semiconductor device as claimed in claim 2, wherein:
the upper film is made of at least one material selected from SiC, SiN, SiCN, W, WSi, SiOF, hydrogen-silsesquioxane, methyl-silsesquioxane, and methyl-hydrogen-silsesquioxane; and/or
the lower film is made of at least one material selected from SiO₂, SiC, SiN, SiCN, W, WSi, SiOF, hydrogen-silsesquioxane, methyl-silsesquioxane, and methyl-hydrogen-silsesquioxane.

17. The semiconductor device as claimed in claim 3, wherein:
the upper film is made of at least one material selected from SiC, SiN, SiCN, W, WSi, SiOF, hydrogen-silsesquioxane, methyl-silsesquioxane, and methyl-hydrogen-silsesquioxane; and/or
the lower film is made of at least one material selected from SiO₂, SiC, SiN, SiCN, W, WSi, SiOF, hydrogen-silsesquioxane, methyl-silsesquioxane, and methyl-hydrogen-silsesquioxane.

18. The semiconductor device as claimed in claim 3, wherein the cap film is made of one material selected from SiON, SiC, SiO₂, SiCN or SiN.

19. The semiconductor device as claimed in claim 4, wherein at least one of the first and the second interlayer insulating films is an organic film.

20. The semiconductor device as claimed in claim 5, wherein at least one of the first and the second interlayer insulating films is an organic film.

21. The semiconductor device as claimed in claim 6, wherein at least one of the first and the second interlayer insulating films is an organic film.

22. The semiconductor device as claimed in claim 7, wherein at least one of the first and the second interlayer insulating films is an organic film.

23. The semiconductor device as claimed in claim 8, wherein at least one of the first and the second interlayer insulating films is an organic film.

24. The semiconductor device as claimed in claim 9, wherein at least one of the first and the second interlayer insulating films is an organic film.

25. The semiconductor device as claimed in claim 10, wherein at least one of the first and the second interlayer insulating films is an organic film.

26. The semiconductor device as claimed in claim 4, wherein at least one of the first and the second interlayer insulating films is evened by using a chemical mechanical polishing method.

27. The semiconductor device as claimed in claim 5, wherein at least one of the first and the second interlayer insulating films is evened by using a chemical mechanical polishing method.

28. The semiconductor device as claimed in claim 6, wherein at least one of the first and the second interlayer insulating films is evened by using a chemical mechanical polishing method.

29. The semiconductor device as claimed in claim 7, wherein at least one of the first and the second interlayer insulating films is evened by using a chemical mechanical polishing method.

30. The semiconductor device as claimed in claim 8, wherein at least one of the first and the second interlayer insulating films is evened by using a chemical mechanical polishing method.

31. The semiconductor device as claimed in claim 9, wherein at least one of the first and the second interlayer insulating films is evened by using a chemical mechanical polishing method.

32. The semiconductor device as claimed in claim 10, wherein at least one of the first and the second interlayer insulating films is evened by using a chemical mechanical polishing method.

33. The semiconductor device as claimed in claim 5, wherein the stopper film is evened by using a chemical mechanical polishing method.

34. The semiconductor device as claimed in claim 8, wherein the stopper film is evened by using a chemical mechanical polishing method.

35. The semiconductor device as claimed in claim 9, wherein the stopper film is evened by using a chemical mechanical polishing method.

36. The semiconductor device as claimed in claim 10, wherein the stopper film is evened by using a chemical mechanical polishing method.

37. The semiconductor device as claimed in claim 6, wherein the two different materials are employed to acquire etching selectivity between the upper film and the lower film and etching selectivity between the upper film and the interlayer insulating film disposed immediately under the lower film.

38. The semiconductor device as claimed in claim 8, wherein the two different materials are employed to acquire etching selectivity between the upper film and the lower film and etching selectivity between the upper film and the interlayer insulating film disposed immediately under the lower film.

39. The semiconductor device as claimed in claim 10, wherein the two different materials are employed to acquire etching selectivity between the upper film and the lower film and etching selectivity between the upper film and the interlayer insulating film disposed immediately under the lower film.

40. The semiconductor device as claimed in claim 6, wherein:
the upper film is made of at least one material selected from SiC, SiN, SiCN, W, WSi, SiOF, hydrogen-silsesquioxane, methyl-silsesquioxane, and methyl-hydrogen-silsesquioxane; and/or
the lower film is made of at least one material selected from SiO₂, SiC, SiN, SiCN, W, WSi, SiOF, hydrogen-silsesquioxane, methyl-silsesquioxane, and methyl-hydrogen-silsesquioxane.

41. The semiconductor device as claimed in claim 8, wherein:
the upper film is made of at least one material selected from SiC, SiN, SiCN, W, WSi, SiOF, hydrogen-silsesquioxane, methyl-silsesquioxane, and methyl-hydrogen-silsesquioxane; and/or
the lower film is made of at least one material selected from SiO₂, SiC, SiN, SiCN, W, WSi, SiOF, hydrogen-silsesquioxane, methyl-silsesquioxane, and methyl-hydrogen-silsesquioxane.

42. The semiconductor device as claimed in claim 10, wherein:
the upper film is made of at least one material selected from SiC, SiN, SiCN, W, WSi, SiOF, hydrogen-silsesquioxane, methyl-silsesquioxane, and methyl-hydrogen-silsesquioxane; and/or
the lower film is made of at least one material selected from SiO₂, SiC, SiN, SiCN, W, WSi, SiOF, hydrogen-silsesquioxane, methyl-silsesquioxane, and methyl-hydrogen-silsesquioxane.

43. The semiconductor device as claimed in claim 5, wherein the stopper film is made of at least one material selected from SiO₂, SiN, SiCN, SiC, SiOF, hydrogen-silsesquioxane, methyl-silsesquioxane, and methyl-hydrogen-silsesquioxane.

44. The semiconductor device as claimed in claim 8, wherein the stopper film is made of at least one material selected from SiO₂, SiN, SiCN, SiC, SiOF, hydrogen-silsesquioxane, methyl-silsesquioxane, and methyl-hydrogen-silsesquioxane.

45. The semiconductor device as claimed in claim 9, wherein the stopper film is made of at least one material selected from SiO₂, SiN, SiCN, SiC, SiOF, hydrogen-silsesquioxane, methyl-silsesquioxane, and methyl-hydrogen-silsesquioxane.

46. The semiconductor device as claimed in claim 10, wherein the stopper film is made of at least one material selected from SiO₂, SiN, SiCN, SiC, SiOF, hydrogen-silsesquioxane, methyl-silsesquioxane, and methyl-hydrogen-silsesquioxane.

47. The semiconductor device as claimed in claim 7, wherein the cap film is made of one material selected from SiON, SiC, SiO₂, SiCN or SiN.

48. The semiconductor device as claimed in claim 9, wherein the cap film is made of one material selected from SiON, SiC, SiO₂, SiCN or SiN.

49. The semiconductor device as claimed in claim 10, wherein the cap film is made of one material selected from SiON, SiC, SiO₂, SiCN or SiN.

50. A method for manufacturing a semiconductor device wherein an interlayer insulating film is formed over an underlayer wiring, a via plug and an upperlayer wiring are almost simultaneously formed in a via hole and a wiring trench, respectively, that are formed through the interlayer insulating film, and the underlayer wiring and the upperlayer wiring are linked through the via plug, comprising:
an interlayer insulating film forming step for forming the interlayer insulating film on a cap film over the underlayer wiring;
a dual hard mask forming step for forming a dual hard mask in which two different kinds of materials are stacked as a lower film and an upper film on the interlayer insulating film;
an interlayer insulating film fabricating step for almost simultaneously forming the via hole and the wiring trench through the interlayer insulating film with the use of the dual hard mask as an etch mask; and
a wiring forming step for almost simultaneously forming the via plug and the upperlayer wiring in the via hole and the wiring trench, respectively.

51. A method for manufacturing a semiconductor device wherein a first interlayer insulating film and a second interlayer insulating film are stacked in this order over an underlayer wiring, a via plug and an upperlayer wiring are almost simultaneously formed in a via hole and a wiring trench, respectively, that are formed through the respective first and second interlayer insulating films, and the underlayer wiring and the upperlayer wiring are linked through the via plug, comprising:
a first interlayer insulating film forming step for forming a first interlayer insulating film on a cap film over the underlayer wiring;
a second interlayer insulating film forming step for forming a second interlayer insulating film over the first interlayer insulating film;
a dual hard mask forming step for forming a dual hard mask in which two different kinds of materials are stacked as a lower film and an upper film on the second interlayer insulating film;
an interlayer insulating film fabricating step for almost simultaneously forming the via hole and the wiring trench through the respective first and second interlayer insulating films with the use of the dual hard mask as an etch mask; and
a wiring forming step for almost simultaneously forming the via plug and the upperlayer wiring in the via hole and the wiring trench, respectively.

52. The method for manufacturing the semiconductor device as claimed in claim 50, wherein one material selected from SiON, SiC, SiO₂, SiCN or SiN is used for the cap film.

53. The method for manufacturing the semiconductor device as claimed in claim 51, wherein one material selected from SiON, SiC, SiO₂, SiCN or SiN is used for the cap film.

54. The method for manufacturing the semiconductor device as claimed in claim 50, wherein:
one material selected from SiON, SiC, SiO₂, SiCN or SiN is used for the cap film; and
when using the SiO₂ as the cap film, the interlayer insulating film fabricating step is conducted with the use of etching gas including C₄F₄, CO, Ar, and O₂, C₄F₈, C₅F₈, and/or CHF₃.

55. The method for manufacturing the semiconductor device as claimed in claim 51, wherein:
one material selected from SiON, SiC, SiO₂, SiCN or SiN is used for the cap film; and
when using the SiO₂ as the cap film, the interlayer insulating film fabricating step is conducted with the use of etching gas including C₄F₄, CO, Ar, and O₂, C₄F₈, C₅F₈, and/or CHF₃.

56. The method for manufacturing the semiconductor device as claimed in claim 50, wherein:
at least one material selected from SiC, SiN, SiCN, W, WSi, SiOF, hydrogen-silsesquioxane, methyl-silsesquioxane, and methyl-hydrogen-silsesquioxane is used for the upper film of the dual hard mask; and/or
at least one material selected from SiO₂, SiC, SiN, SiCN, W, WSi, SiOF, hydrogen-silsesquioxane, methyl-silsesquioxane, and methyl-hydrogen-silsesquioxane is used for the lower film of the dual hard mask.

57. The method for manufacturing the semiconductor device as claimed in claim 51, wherein:
at least one material selected from SiC, SiN, SiCN, W, WSi, SiOF, hydrogen-silsesquioxane, methyl-silsesquioxane, and methyl-hydrogen-silsesquioxane is used for the upper film of the dual hard mask; and/or
at least one material selected from SiO₂, SiC, SiN, SiCN, W, WSi, SiOF, hydrogen-silsesquioxane, methyl-silsesquioxane, and methyl-hydrogen-silsesquioxane is used for the lower film of the dual hard mask.

58. The method for manufacturing the semiconductor device as claimed in claim 50, wherein:
at least one material selected from SiC, SiN, SiCN, W, WSi, SiOF, hydrogen-silsesquioxane, methyl-silsesquioxane, and methyl-hydrogen-silsesquioxane is used for the upper film of the dual hard mask; and/or
at least one material selected from SiO₂, SiC, SiN, SiCN, W, WSi, SiOF, hydrogen-silsesquioxane, methyl-silsesquioxane, and methyl-hydrogen-silsesquioxane is used for the lower film of the dual hard mask; and
when using the SiC and/or the SiO₂ as the upper film and the lower film, respectively, the interlayer insulating film fabricating step is conducted with the use of etching gas including CF₄, O₂ and N₂ in the respective ranges of 20 to 40 standard cubic centimeters per minute, 10 to 50 standard cubic centimeters per minute, and 80 to 150 standard cubic centimeters per minute under a condition where pressure is 10 to 100 mTorr.

59. The method for manufacturing the semiconductor device as claimed in claim 51, wherein:
at least one material selected from SiC, SiN, SiCN, W, WSi, SiOF, hydrogen-silsesquioxane, methyl-silsesquioxane, and methyl-hydrogen-silsesquioxane is used for the upper film of the dual hard mask; and/or
at least one material selected from SiO₂, SiC, SiN, SiCN, W, WSi, SiOF, hydrogen-silsesquioxane, methyl-silsesquioxane, and methyl-hydrogen-silsesquioxane is used for the lower film of the dual hard mask; and
when using the SiC and/or the SiO₂ as the upper film and the lower film, respectively, the interlayer insulating film fabricating step is conducted with the use of etching gas including CF₄, O₂ and N₂ in the respective ranges of 20 to 40 standard cubic centimeters per minute, 10 to 50 standard cubic centimeters per minute, and 80 to 150 standard cubic centimeters per minute under a condition where pressure is 10 to 100 mTorr.
